**Europäisches Patentamt**

**European Patent Office**

**Office européen des brevets**

(19)

(11) **EP 1 345 261 A1**

(12) **EUROPEAN PATENT APPLICATION**
published in accordance with Art. 158(3) EPC

(43) Date of publication:
**17.09.2003 Bulletin 2003/38**

(21) Application number: **01272299.7**

(22) Date of filing: **21.12.2001**

(51) Int Cl.7: **H01L 21/306**

(86) International application number:
**PCT/JP01/11308**

(87) International publication number:
**WO 02/052627 (04.07.2002 Gazette 2002/27)**

(84) Designated Contracting States:
**AT BE CH CY DE DK ES FI FR GB GR IE IT LI LU MC NL PT SE TR**

(30) Priority: **22.12.2000 JP 2000390166**

(71) Applicant: **SEIKO EPSON CORPORATION Shinjuku-ku, Tokyo 163-0811 (JP)**

(72) Inventors:
• **MORI, Yoshiaki,**
  **c/o SEIKO EPSON CORPORATION**
  **Suwa-shi, Nagano 392-8502 (JP)**
• **MIYAKAWA, Takuya,**
  **c/o SEIKO EPSON CORPORATION**
  **Suwa-shi, Nagano 392-8502 (JP)**

• **TAKAGI, Kenichi,**
  **c/o SEIKO EPSON CORPORATION**
  **Suwa-shi, Nagano 392-8502 (JP)**
• **ASUKE, Shintaro,**
  **c/o SEIKO EPSON CORPORATION**
  **Suwa-shi, Nagano 392-8502 (JP)**
• **SATO, Mitsuru,**
  **c/o SEIKO EPSON CORPORATION**
  **Suwa-shi, Nagano 392-8502 (JP)**

(74) Representative: **Hoffmann, Eckart, Dipl.-Ing. Patentanwalt, Bahnhofstrasse 103 82166 Gräfelfing (DE)**

(54) **PATTERN FORMING METHOD AND DEVICE AND SEMICONDUCTOR DEVICE, ELECTRIC CIRCUIT, DISPLAY ELEMENT MODULE AND LUMINOUS ELEMENT**

(57) A pattern material supply unit (300) has a shower head (310) for producing a particle mist from the liquid pattern material (312) and discharging the mist. A process stage (318) on which the workpiece (20) is placed is disposed below the shower head (310). A hydrophobic processed mask with pattern forming openings is disposed on the surface of the workpiece (20). A voltage is applied by a dc power source (328) to the workpiece (20) by way of the intervening process stage (318) so that particles of the liquid pattern material (312) are attracted thereto by static attraction. The liquid pattern material adhering to the mask surface fills in the pattern forming openings disposed in the mask as a result of the process stage (318) rotating, and the liquid pattern material can be heated and solidified by an internal heater (326).

FIG._4

EP 1 345 261 A1

## Description

TECHNICAL FIELD

The present invention relates to the high density mounting and manufacturing of a semiconductor device, liquid crystal device, or other component device having thin-film layers, and relates more particularly to a pattern forming method and apparatus that do not require a reduced pressure environment during device manufacture and can be used for forming patterns near atmospheric pressure, and to devices manufactured by this method.

BACKGROUND ART

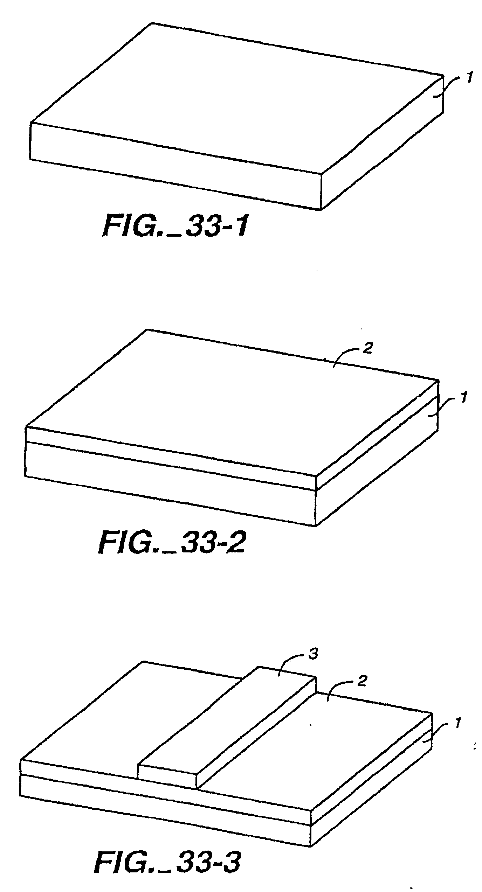

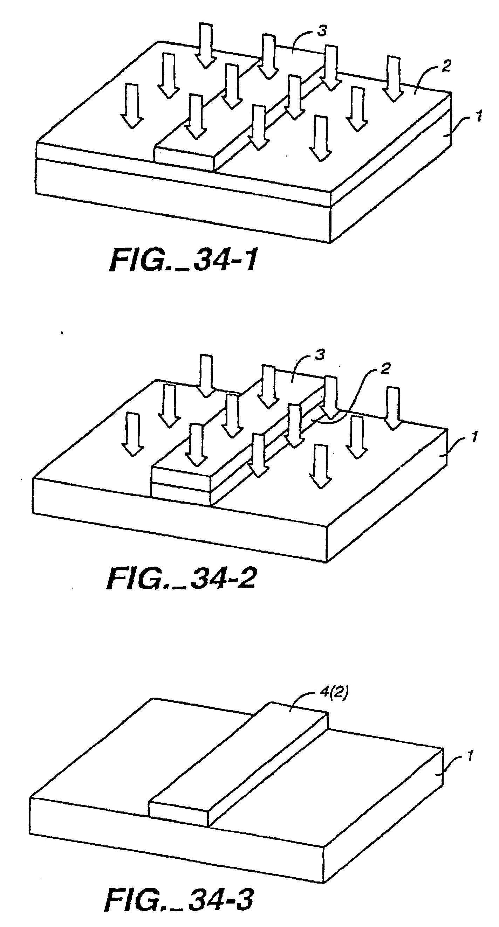

Semiconductor devices are manufactured by repeatedly performing film formation and film patterning operations. Fig. 33 and Fig. 34 are process diagrams showing an example of a conventional patterning process.

When forming wiring, for example, on the surface of a semiconductor substrate 1 as shown in Fig. 33 (1), a wiring layer 2 is first formed as shown in Fig. 33 (2) by plasma CVD on the surface of the semiconductor substrate 1 having formed thereon an insulation film not shown in the figures. It should be noted that this wiring layer 2 may also be formed by sputtering.

After thus forming a wiring layer 2 on the semiconductor substrate 1, the wiring layer 2 is coated with a photoresist to form a resist layer. This resist layer is passed through exposure and photoetching processes to form a patterned resist layer 3 such as shown in Fig. 33 (3).

As shown in Fig. 34 (1), the semiconductor substrate 1 is then introduced to a dry etching process and the wiring layer 2 is etched using the resist layer 3 as a mask. After leaving the wiring layer 2 below only the resist layer 3 as shown in Fig. 34 (2), the resist layer 3 located above the wiring layer 2 is removed with solvent (see Fig. 34 (3)).

A wiring pattern 4 formed from wiring layer 2 can thus be formed through these processes on the surface of semiconductor substrate 1.

However, problems such as described below are presented with the above-described manufacturing process.

That is, most of this conventional patterning process is performed in a vacuum state (reduced pressure environment). Vacuum process equipment is therefore essential to this patterning process. The problem with such vacuum process equipment is that energy consumption including that by basic ancillary equipment for external venting and coolant when the processes are run is massive, accounting for 60% or more of the energy required by the manufacturing process.

Why such massive energy consumption is necessary is due to the following parts of the vacuum process equipment. These include the load lock chamber for transporting work from an atmospheric pressure environment into a vacuum state, plural dry pumps and turbo pumps for lowering the process chamber to a vacuum, the increased footprint required to provide plural chambers in order to improve throughput and the attendant increase in clean room size and increase in basic equipment used to maintain the same.

In addition, vacuum plasma etching is also used in conventional pattern forming processes. Etching with vacuum plasma, however, requires changing the etching gas according to the material of the film to be etched. It is therefore necessary to install etching equipment compatible with the different etching gases used. The equipment thus becomes larger in order to provide plural different types of systems, thus leading to increased equipment costs.

In order to clean reaction products adhering to the inside of the chamber with CVD equipment used for insulation film formation, for example, it has also been necessary to use $CHF_3$, $CF_4$, or other PFC gas with a high global warming coefficient. These PFC gases are also used for etching during pattern forming. Great expense is therefore required with conventional pattern forming processes in order to process waste gas from the etching equipment and waste gas from cleaning the CVD equipment.

DISCLOSURE OF THE INVENTION

The present invention is directed to the problems of the prior art described above, and an object of the invention is to enable forming patterns without using vacuum equipment.

A further object of the present invention is to simplify the equipment for forming patterns, and to reduce the production cost.

A yet further object of the present invention is to reduce the energy used for pattern forming.

Another object of the present invention is to enable forming patterns without using PFC gas.

To achieve the above object, a pattern forming method according to the present invention is characterized by forming a mask having pattern forming openings on a workpiece surface, and then supplying and solidifying a liquid pattern material in the pattern forming openings of the mask. An organometallic compound solution or a solution of a powder of an inorganic material dissolved in solvent can be used as the liquid pattern material.

Thus comprised, the present invention can form a pattern by simply filling and solidifying a liquid pattern material in pattern forming openings formed in a mask disposed on the workpiece surface. The present invention therefore does not need to use high cost vacuum equipment. As a result, the present invention does not require a load lock chamber for transporting work into a vacuum environment, plural dry pumps and turbo pumps for making the process chamber a vacuum, the increased footprint required to provide plural chambers in order to improve throughput and the attendant increase in clean room size and increase in basic equipment used to maintain the same, and therefore helps simplify the equipment, reduce the amount of energy used in pattern forming, and reduce the pattern forming cost. Furthermore, because the present invention does not use CVD, for example, it is not necessary to use PFC gas having a high global warming coefficient in order to clean the film formation equipment, thus reducing cost and significantly reducing the effect on the global environment. A desired pattern can also be easily formed on the surface of a flat workpiece.

A further pattern forming method according to the present invention is characterized by comprising a mask forming process for forming a mask having pattern forming openings on a workpiece surface; a pattern material supplying process for supplying the liquid pattern material to the mask openings while also drying the liquid pattern material; a process for removing the mask from the workpiece; and an annealing process for annealing dried solute of the liquid pattern material.

Thus comprised, the present invention can as noted above form a desired pattern without using vacuum equipment, and can achieve the same effects described above. In addition, because the solute is annealed after drying and solidifying the liquid pattern material supplied to the pattern forming openings of the mask by evaporating solvent in the liquid pattern material, the occurrence of voids due to rapid heating can be avoided and a deformation-free pattern with low internal stress can be achieved even when a high temperature is required to sufficiently solidify the solute. Moreover, because supplying the liquid pattern material and drying the liquid pattern material occur at the same time, the present invention can shorten the time needed to dry the liquid pattern material and can simplify the process. Yet further, because the solute is annealed after removing the mask, the solute can be annealed at a high temperature without resulting in carbonization of the mask and other results that are undesirable for the mask, and a detailed pattern can thus be formed.

A further pattern forming method according to the present invention is characterized by comprising a mask forming process for forming a mask having pattern forming openings on a workpiece surface; a pattern material supplying process for supplying a liquid pattern material to the mask openings; a drying process for evaporating solvent in the liquid pattern material; a mask removal process for removing the mask from the workpiece; and an annealing process for annealing dried solute in the liquid pattern material.

In this case the liquid pattern material can be dried after finishing supplying the liquid pattern material to the pattern forming openings of the mask. As a result, this aspect of the invention can easily and reliably dry the liquid pattern material and enable efficient pattern forming even when some time is required to dry the liquid pattern material.

A further pattern forming method according to the present invention is characterized by comprising a mask forming process for forming a mask having pattern forming openings on a workpiece surface; a pattern material supplying process for supplying a liquid pattern material to the mask openings; a solidifying process for solidifying the liquid pattern material supplied into the openings; and a mask removal process for removing the mask from the workpiece after sequentially performing plural times the pattern material supply process and solidifying process.

By thus supplying the liquid pattern material to the pattern forming openings of the mask plural times and solidifying the liquid pattern material each time the pattern material is supplied, a detailed pattern with extremely low distortion can be formed and a good pattern configuration can be achieved. It is also possible to easily form patterns with a thick film thickness that are difficult to form when the liquid pattern material is supplied in one step.

A further pattern forming method according to the present invention is characterized by comprising a mask forming process for forming a mask having pattern forming openings on a workpiece surface; a pattern material supplying process for supplying a liquid pattern material to the mask openings; an adherent liquid removal process for removing liquid pattern material that adhered to the mask surface when the liquid pattern material was supplied to the openings; a drying process for drying by evaporating solvent in the liquid pattern material in the openings; an annealing process for annealing the dried solute after sequentially performing plural times the pattern material supply process, adherent liquid removal process, and drying process; and a mask removal process for removing the mask from the workpiece.

By thus supplying the liquid pattern material to the pattern forming openings of the mask plural times and drying and annealing the liquid pattern material each time the pattern material is supplied, a detailed, thick film thickness pattern with little distortion can be achieved. Furthermore, because liquid pattern material adhering to the mask surface is removed before drying the liquid pattern material, unnecessary material adhering to the mask surface that is difficult to remove when dry can be removed easily, and mask removal also becomes simple.

A further pattern forming method according to the present invention is characterized by comprising a mask forming process for forming a mask having pattern forming openings on a workpiece surface; a pattern material supplying process for supplying a liquid pattern material to the mask openings; a drying process for drying by evaporating solvent in the liquid pattern material in the openings; and an annealing process for annealing the dried solute after sequentially performing plural times the pattern material supply process and drying process.

The invention thus comprised can achieve an extremely low distortion, detailed pattern having an excellent shape with little deformation. This aspect of the invention is particularly useful for pattern forming not requiring mask removal, such as when the mask is formed from $SiO_2$ or other dielectric material and a wiring pattern is formed from a conductive material.

A yet further pattern forming method according to the present invention is characterized by comprising a mask forming process for forming a mask having pattern forming openings on a workpiece surface; a pattern material supplying process for supplying a liquid pattern material to the mask openings; a solidifying process for solidifying the liquid pattern material supplied into the trenches; a solid material removal process for removing solids of the liquid pattern material that adhered to the mask surface when the liquid pattern material was supplied to the mask openings; and a mask removal process for removing the mask from the workpiece after sequentially performing plural times the pattern material supply process, solidifying process, and solid material removal process.

By thus supplying the liquid pattern material to the pattern forming openings of the mask plural times and solidifying the liquid pattern material each time the pattern material is supplied, a detailed, pattern with even less internal stress can be achieved. Furthermore, because solids adhering to the mask are removed each time the liquid pattern material is supplied to the mask openings, the solids can be removed relatively easily.

A further pattern forming method according to the present invention is characterized by comprising a mask forming process for forming a mask having pattern forming openings on a workpiece surface; a pattern material supplying process for supplying a liquid pattern material to the mask openings; a drying process for drying by evaporating solvent in the liquid pattern material in the openings; a solid material removal process for removing dried solids of the liquid pattern material that adhered to the mask surface when the liquid pattern material was supplied to the mask openings; an annealing process for annealing the dried solute after sequentially performing plural times the pattern material supply process, drying process, solid material removal process; and a mask removal process for removing the mask from the workpiece.

By thus drying the liquid pattern material each time the liquid pattern material is supplied to the pattern forming openings in the mask, this aspect of the invention can also achieve a detailed pattern with low internal stress. Furthermore, the solids can be removed relatively easily because solids adhering to the mask surface are removed each time the liquid pattern material is dried.

A yet further pattern forming method according to the present invention is characterized by comprising a mask forming process for forming a mask having pattern forming openings on a workpiece surface; a pattern material supplying process for supplying a liquid pattern material to the mask openings; a drying process for drying by evaporating solvent in the liquid pattern material in the openings; a solid material removal process for removing dried solids of the liquid pattern material that adhered to the mask surface when the liquid pattern material was supplied to the mask openings; an annealing process for annealing the dried solute; and a mask removal process for removing the mask from the workpiece after sequentially performing plural times the pattern material supply process, drying process, solid material removal process, and annealing process.

By thus drying and annealing the liquid pattern material each time the liquid pattern material is supplied to the pattern forming openings in the mask, this aspect of the invention can achieve a detailed pattern with extremely low internal stress, and can easily form a pattern with a thick film thickness.

At least the surface of the mask is preferably hydrophobic. If the workpiece is then rotated, for example, when supplying the liquid pattern material to the pattern forming openings in the mask, liquid pattern material on the workpiece surface will move easily over the workpiece surface and into the openings, and the liquid pattern material can thus be supplied easily, quickly, and evenly into the pattern forming openings. Material adhering to the mask surface can also be easily removed because the mask surface is hydrophobic.

The mask can be formed from a fluororesin or other hydrophobic material. If the mask is thus formed from a hydrophobic material, a process for imparting hydrophobic to the mask can be omitted, and the process can be simplified.

In the case of the invention as described in claim 1, claim 4, or claim 7, the liquid pattern material is solidified by applying heat. Solidification by heating does not require expensive equipment, is very safe because curing chemicals are not needed, and thus helps simplify the process. Depending upon the liquid pattern material, the liquid pattern material can, of course, be solidified by emitting, for example, an electron beam or ultraviolet light.

Heating and solidifying the liquid pattern material can as necessary comprise a drying process and an annealing process. This makes it possible to avoid producing voids in the pattern or deforming the pattern shape, and can achieve a detailed pattern with low internal stress. It will be noted, however, that the annealing process is not required if sufficient solidification is possible at a drying temperature of, for example, 80° to 120°C. Yet further, the drying process can be omitted if the process can start at a high temperature without causing any problems.

In the pattern forming method as described in claim 1, the mask is removed according to need. For example, if the mask is made from a photoresist, the mask is removed by ashing in ozonated water or activated oxygen under atmospheric pressure.

In the pattern forming method as described in any of claims 1 to 4, the liquid pattern material is preferably solidified after removing liquid pattern material adhering to the mask surface. By thus removing material from the mask surface while still liquid, even materials that are difficult to remove once solidified can be easily removed, and the mask, for example, can also be easily removed.

In the pattern forming method as described in claim 6, the annealing process is performed according to need after removing the mask from the workpiece. By first removing the mask when the annealing temperature exceeds the allowable temperature of the mask, sufficient annealing can be achieved and it is possible to avoid making mask removal difficult as a result of annealing changing the properties of the mask.

In the pattern forming method as described in claim 2, claim 3, claim 5, claim 7, or claim 8, removing the mask and annealing the solute can be accomplished simultaneously by forming the mask from a material with a high breakdown temperature. As a result, the process can be simplified.

A further pattern forming method according to the present invention is characterized by comprising a mask forming process for forming a mask having pattern forming openings on a workpiece surface; a pattern material supplying process for supplying the liquid pattern material to the mask openings while also drying the liquid pattern material; an annealing process for annealing dried solute of the liquid pattern material; and a process for removing the mask from the workpiece.

By supplying the liquid pattern material to pattern forming openings in the mask, and drying and annealing it to solidify, the present invention thus comprised can easily form a pattern without using vacuum equipment, and thus achieves the same effects described above. Moreover, because supplying and drying the liquid pattern material occur at the same time, the pattern forming time can be shortened and the process simplified. In addition, the invention prevents producing voids in the formed pattern, and prevents deformation of the formed pattern, because annealing occurs after drying the liquid pattern material.

A further pattern forming method according to the present invention is characterized by comprising a mask forming process for forming a mask having pattern forming openings on a workpiece surface; a pattern material supplying process for supplying a liquid pattern material to the mask openings; a drying process for evaporating solvent in the liquid pattern material; an annealing process for annealing dried solute in the liquid pattern material; and a mask removal process for removing the mask from the workpiece.

This aspect of the present invention also does not require vacuum equipment, and achieves the same effects described above. Moreover, because drying the liquid pattern material occurs after supplying the liquid pattern material to the pattern forming openings is completed, even liquid pattern materials that take a relatively long time to dry can be reliably dried, and a pattern free of voids and deformation can be reliably formed.

A further pattern forming method according to the present invention is characterized by comprising a mask forming process for forming a mask having pattern forming openings on a workpiece surface; a pattern material supplying process for supplying a liquid pattern material to the mask openings; an adherent liquid removal process for removing liquid pattern material that adhered to the mask surface when the liquid pattern material was supplied to the openings; a drying process for drying by evaporating solvent in the liquid pattern material in the openings; a mask removal process for removing the mask from the workpiece after sequentially performing plural times the pattern material supply process, adherent liquid removal process, and drying process; and an annealing process for annealing the dried solute.

By thus supplying the liquid pattern material to the pattern forming openings in the mask over plural steps and drying the liquid pattern material each time the liquid pattern material is supplied, the invention thus comprised can achieve a detailed pattern with low internal stress. Material adhering to the mask surface can also be easily removed because liquid pattern material adhering to the mask surface is removed before it solidifies.

A yet further pattern forming method according to the present invention is characterized by comprising a mask forming process for forming a mask having pattern forming openings on a workpiece surface; a pattern material supplying process for supplying a liquid pattern material to the mask openings; a drying process for drying by evaporating solvent in the liquid pattern material in the openings; a solid material removal process for removing dried solids of the liquid pattern material that adhered to the mask surface when the liquid pattern material was supplied to the mask openings; a mask removal process for removing the mask from the workpiece after sequentially performing plural times the pattern material supply process, drying process, and solid material removal process; and an annealing process for annealing the dried solute.

By thus repeatedly supplying and drying the liquid pattern material in the pattern forming openings in the mask, the invention thus comprised can achieve a detailed pattern with low internal stress and few voids. In addition, unneeded material adhering to the mask surface can be removed relatively easily because the solids are removed after each drying process.

A further pattern forming method according to the present invention is characterized by supplying and solidifying a liquid pattern material in a specific pattern forming trench disposed in a workpiece.

The invention thus comprised can easily form a pattern without using vacuum equipment, and thereby achieve the same effects described above, because it simply supplies and then solidifies the liquid pattern material in the pattern forming trenches disposed in the workpiece. Yet further, this aspect of the invention can form a wiring pattern by simply supplying and solidifying a liquid pattern material such as an organometallic compound solution to wiring trenches formed in a dielectric film by means of a conventional method, for example. More specifically, the present invention can form various types of patterns by use in combination with a conventional method, and can thus be used to form a wide range of patterns.

A further pattern forming method according to the present invention is characterized by performing plural times a process for supplying and solidifying a liquid pattern material in a specific pattern forming trench disposed in a workpiece.

In addition to achieving the same effects described above as a result of not using vacuum equipment, the invention thus comprised can form a detailed pattern with extremely low internal stress, and can easily form a pattern with a thick film thickness, as a result of forming the pattern by supplying and solidifying the liquid pattern material in the pattern forming trenches plural times.

A further pattern forming method according to the present invention is characterized by comprising a pattern material supply process for supplying a liquid pattern material to a specific pattern forming trench disposed in a workpiece; an adherent liquid removal process for removing liquid pattern material that adhered to the mask surface when the liquid pattern material was supplied to the trench; a drying process for drying by evaporating solvent in the liquid pattern material in the trench; and an annealing process for annealing solute contained in the dried liquid pattern material after sequentially performing plural times the pattern material supply process, adherent liquid removal process, and drying process.

By thus drying the liquid pattern material supplied to the pattern forming trenches and then again supplying and drying the liquid pattern material in the trenches, the invention thus comprised can form a pattern with a good shape, and can form a detailed pattern. In addition, because liquid pattern material on the workpiece surface is removed before the liquid pattern material is dried, material adhering to the workpiece surface that can be difficult to remove when it solidifies can be removed easily. Furthermore, because material adhering to the workpiece surface is removed, accidents resulting from the presence of electrically undesirable adherent material can be prevented, and reliability can be improved.

A further pattern forming method according to the present invention is characterized by sequentially performing plural times a pattern material supply process for supplying a liquid pattern material to a specific pattern forming trench disposed in a workpiece; a solidifying process for heating and solidifying the liquid pattern material supplied to the trench; and an adherent solid removal process for removing solids of the liquid pattern material that adhered to the workpiece surface when the liquid pattern material was supplied to the trench.

The invention thus comprised can achieve a detailed pattern with even lower internal stress as a result of supplying the liquid pattern material to the pattern forming trenches and heat solidifying the material plural times. Processing is also simplified by removing solids adhering to the workpiece surface as the final step.

A further pattern forming method according to the present invention is characterized by comprising a pattern material supply process for supplying a liquid pattern material to a specific pattern forming trench disposed in a workpiece; a drying process for evaporating solvent in the liquid pattern material supplied to the trench; and an annealing process for annealing solute contained in the dried liquid pattern material after sequentially performing plural times the pattern material supply process and drying process.

By thus supplying and drying the liquid pattern material in the pattern forming trenches plural times, the invention thus comprised can form a detailed pattern with low internal stress and little deformation. It is also possible to prevent voids in the pattern even when forming a thick pattern.

A further pattern forming method according to the present invention is characterized by comprising a pattern material supply process for supplying a liquid pattern material to a specific pattern forming trench disposed in a workpiece; a drying process for evaporating solvent in the liquid pattern material supplied to the trench; an adherent solid removal process for removing dried solids of the liquid pattern material that adhered to the workpiece surface when the liquid pattern material was supplied to the trench; and an annealing process for annealing solute contained in the dried liquid pattern material after sequentially performing plural times the pattern material supply process, drying process, and adherent solid removal process.

By drying the liquid pattern material supplied to the pattern forming trenches and then annealing the solute, the invention thus comprised can prevent voids, for example, in the pattern, and can form a detailed pattern with low internal stress. Furthermore, solids adhering to the workpiece surface can be removed relatively easily because the dried solids are removed after drying the liquid pattern material and before annealing. Yet further, by supplying the liquid pattern material to the pattern forming trenches, drying, and removing the adherent solids plural times, a detailed pattern with extremely low internal stress can be achieved and a pattern with a thick film thickness can be easily formed.

A further pattern forming method according to the present invention is characterized by performing once or plural times a pattern material supply process for supplying a liquid pattern material to a specific pattern forming trench disposed in a workpiece; a drying process for evaporating solvent in the liquid pattern material supplied to the trench; an adherent solid removal process for removing dried solids of the liquid pattern material that adhered to the workpiece surface when the liquid pattern material was supplied to the trench; and an annealing process for annealing solute contained in the dried liquid pattern material.

By thus drying the liquid pattern material supplied to the pattern forming trenches and then annealing the solute, the invention thus comprised can achieve a pattern with good shape precision and without voids in the formed pattern. Furthermore, by supplying the liquid pattern material to the pattern forming trenches, drying, removing adherent solids, and annealing plural times, a detailed pattern with good shape precision and even less distortion can be formed, and even patterns with a thick film thickness can be easily achieved.

In a pattern forming method as described in any of claims 23 to 29, the liquid pattern material is preferably supplied to the trench after hydrophobic processing the workpiece surface. By thus hydrophobic processing the workpiece surface, the liquid pattern material can be supplied quickly and evenly into the trenches by, for example, rotating the workpiece when supplying the liquid pattern material to the pattern forming trenches because liquid pattern material on the workpiece surface will move easily into the pattern forming trenches. Material adhering to the workpiece surface can also be easily removed because the workpiece surface is hydrophobic.

Yet further, in a pattern forming method as described in any of claims 23 to 29 the liquid pattern material is preferably supplied to the pattern forming trenches after hydrophobic processing the workpiece surface and hydrophilic processing the bottom of the pattern forming trenches. In addition to being able to easily remove material adhering to the workpiece surface, it is also possible in this case to improve adhesion between the formed pattern and the workpiece.

Yet further, in a pattern forming method as described in claim 23, claim 26, or claim 26, the liquid pattern material can be solidified by heating. If the liquid pattern material is solidified by heating, chemicals and expensive equipment are not needed, and solidifying the liquid pattern material can be done safely and easily. Heat solidification of the liquid pattern material can comprise a drying process for evaporating solvent in the liquid pattern material, and an annealing process for annealing the solute. The occurrence of voids can be prevented, and a detailed pattern with low internal stress and good shape precision can be formed, by thus annealing after drying the liquid pattern material.

In a pattern forming method as described in claim 23, solids of the liquid pattern material adhering to the workpiece surface are removed after solidifying the liquid pattern material. The workpiece surface thus becomes clean, and unexpected accidents, for example, resulting from unnecessary adherent material on the workpiece surface can be prevented.

Yet further, in a pattern forming method as described in claim 23 solidifying the liquid pattern material occurs after removing liquid pattern material that adhered to the workpiece surface when the liquid pattern material was supplied to the trench. As a result, adherent material on the workpiece surface that is difficult to remove when solidified can be removed easily.

In a pattern forming method as described in claim 27, the annealing process can be performed after removing dried solids of liquid pattern material that adhered to the workpiece surface when the liquid pattern material was supplied to the trench. As a result, adherent material on the workpiece surface that is difficult to remove when annealed can be removed relatively easily.

A further pattern forming method according to the present invention is characterized by comprising a process for disposing an organic film on a workpiece surface; a process for forming a trench of a specific pattern in the organic film; a process for filling the trench with an inorganic material; a process for removing inorganic material except from inside the trench; and a process for removing the organic film and leaving a pattern of the inorganic material.

More specifically, the above described processes of the present invention can also be performed in an environment at atmospheric pressure or near atmospheric pressure. As a result, it is not necessary to provide vacuum equipment, and the energy needed to run the equipment can be reduced. Furthermore, because of the change from a process for removing a formation on the workpiece surface to a process for adding to or filling trenches, it is possible to eliminate the use of PFC gas used for removing material adhering to a conventional system. The cost of pattern forming can therefore be reduced, and the effect on the global environment is small.

The process for filling the trench with an inorganic material can be accomplished by applying a solution containing the inorganic material. Because the inorganic material is thus fluid, it reliably penetrates the trenches and can reliably cover the organic film. The inorganic material can be a liquid or a gas-liquid mixture. If a gas-liquid mixture, it can be easily coated to the workpiece at atmospheric pressure. Furthermore, if it is a gas-liquid mixture, the composition of the formed film can be freely improved by means of an added gas.

The inorganic material can be applied by spin coating. By spin coating the inorganic material, the inorganic material can be evenly coated to the workpiece surface by centrifugal force, and the inorganic material can be reliably applied throughout the trenches. The inorganic material can also be applied by spraying. In this case the inorganic material can be sprayed with a desired pressure into the top layer of the organic film so that the inorganic material reliably fills the trenches due to the applied pressure.

The process for removing inorganic material except inside the trenches is accomplished by applying an etching solution. When the inorganic material is removed using an etching solution, the etching solution spreads easily over the entire surface of the inorganic material because of its fluidity so that the entire surface of the inorganic material can be reliably etched. The etching solution can be a liquid or a liquid-gas mixture. As a result, it can be easily coated to the workpiece at atmospheric pressure. If it is a gas-liquid mixture, the composition of the formed film can be freely improved by means of an added gas. The etching solution can also be applied by spin etching. By spin etching, the etching solution can be evenly coated to the workpiece surface by centrifugal force, and a uniform etching rate can be achieved. The etching solution can also be applied by spraying. In this case the etching solution can be sprayed with the desired pressure into the top layer of the inorganic material so that the etching solution reliably covers the entire surface of the inorganic material and the etching process can be reliably performed.

The process for removing inorganic material except inside the trench can be accomplished by CMP. By using CMP, the inorganic material can be evenly removed and the organic film can be removed at atmospheric pressure without providing vacuum equipment, and it is therefore possible to save the energy needed to operate vacuum equipment.

The organic film can also be removed with atmospheric pressure plasma. By removing the organic film with atmospheric pressure plasma, the organic film can be removed at atmospheric pressure without providing vacuum equipment, and it is therefore possible to save the energy needed to operate vacuum equipment.

A pattern forming apparatus for applying a pattern forming method described above is characterized by comprising a mask forming unit for forming a mask by disposing pattern forming openings in a mask material coated to and solidified on a workpiece surface; a hydrophobic processing unit for hydrophobic processing the solidified mask material or mask; a pattern material supply unit for supplying a liquid pattern material to the pattern forming openings of the mask; and a solidification unit for solidifying the liquid pattern material in the pattern forming openings.

The invention thus comprised can make the equipment compact, reduce energy consumption, and reduce costs involved with forming patterns because vacuum equipment is not used. Moreover, the present invention does not need to use PFC gas, and can reduce the burden on the global environment.

A further pattern forming apparatus according to the present invention is characterized by comprising a mask forming unit for forming a mask by disposing pattern forming openings in a mask material coated to and solidified on a workpiece surface; a hydrophobic processing unit for hydrophobic processing the solidified mask material or mask; a pattern material supply unit for supplying a liquid pattern material to the pattern forming openings of the mask; a solidification unit for solidifying the liquid pattern material in the pattern forming openings; and a mask removal unit for removing the mask after solidifying the liquid pattern material. The invention thus comprised achieves the same effects described above.

The hydrophobic processing unit can comprise a plasma generating means for producing a fluoride gas plasma at or near atmospheric pressure and supplying the plasma to the solidified mask material or mask. By generating and supplying a fluoride gas plasma to the mask material or mask, the solidified mask material or mask can be easily processed for hydrophobic. A hydrophobic mask can thus be easily formed.

The hydrophobic processing unit can comprise a polymerization means for producing a fluorocompound plasma, and polymerizing a fluororesin film on the surface of the solidified mask material or mask. By thus forming a polymer film from a hydrophobic fluororesin to accomplish the hydrophobic process, even silicon and glass, which cannot be made hydrophobic with active fluorine, can be easily hydrophobic processed. The hydrophobic processing unit preferably comprises a hydrophilic processing means for making inside the pattern forming openings of the hydrophobic processed mask hydrophilic. By making inside the hydrophobic processed pattern forming openings hydrophilic by means of the hydrophilic processing means, adhesion of the formed pattern to the workpiece can be improved.

A further pattern forming apparatus according to the present invention is characterized by comprising a mask forming unit for forming a mask comprising a hydrophobic film having pattern forming openings on the surface of a workpiece; a pattern material supply unit for supplying a liquid pattern material to the pattern forming openings of the mask; a solidification unit for solidifying the liquid pattern material in the pattern forming openings; and a mask removal unit for removing the mask after solidifying the liquid pattern material. With the invention thus comprised processing the mask for hydrophobic is not necessary because the mask itself is hydrophobic, and the equipment can therefore be simplified.

The mask forming unit can comprise a polymerization means for producing a fluorocompound plasma and polymerizing a fluororesin film on the surface of the workpiece through a transfer mask. A hydrophobic mask can thus be easily formed.

The pattern material supply unit can comprise an adherent liquid removal means for removing liquid pattern material adhering to the mask surface. This enables material adhering to the mask to be removed before the liquid pattern material adhering to the mask solidifies, and adherent material can thus be easily removed.

The pattern material supply unit can comprise an atomization means for atomizing and misting the liquid pattern material on the mask. By thus atomizing the liquid pattern material by means of the atomization means, a detailed pattern can be formed using a liquid pattern material. The pattern material supply unit can also comprise a rotating means for rotating the workpiece. Liquid pattern material adhering to the workpiece surface can be supplied to the pattern forming openings by spinning the workpiece by means of the rotating means, and the liquid pattern material can be evenly supplied to each of the pattern forming openings throughout the workpiece. Excess liquid pattern material adhering to the workpiece can also be removed by centrifugal force by spinning the workpiece.

The pattern material supply unit further preferably has a voltage applying means for applying a dc voltage to the workpiece so that static attraction works to attract the atomized liquid pattern material to the workpiece. The fill rate of the liquid pattern material to the pattern forming trenches can be increased by applying a voltage to the workpiece to attract the atomized liquid pattern material.

The solidification unit comprises a heating means disposed in the pattern material supply unit for heating and solidifying the liquid pattern material. By providing a heating means as the solidification unit in the pattern supply unit, the liquid pattern material supplied to the pattern forming openings can be heated and solidified while supplying the liquid pattern material to the pattern forming openings, and the time required for pattern forming can be shortened.

A semiconductor device according to the present invention is manufactured using any of the above pattern forming methods according to the present invention. A semiconductor device with the above described advantages can thus be manufactured.

An electrical circuit according to the present invention is manufactured using any of the above pattern forming methods according to the present invention. An electrical circuit with the above described advantages can thus be manufactured.

A display module according to the present invention is manufactured using any of the above pattern forming methods according to the present invention. A display module with the above described advantages can thus be manufactured.

A color filter according to the present invention is manufactured using any of the above pattern forming methods according to the present invention. A color filter with the above described advantages can thus be manufactured.

A light-emitting element according to the present invention is manufactured using any of the above pattern forming methods according to the present invention. A light-emitting element with the above described advantages can thus be manufactured.

BRIEF DESCRIPTION OF THE DRAWINGS

Fig. 1   is a schematic block diagram of a pattern forming apparatus according to a first embodiment of the present invention;

Fig. 2   is a descriptive diagram of the mask forming unit of a pattern forming apparatus according to a first embodiment of the present invention;

Fig. 3   is a descriptive diagram of the hydrophobic processing unit of the pattern forming apparatus according to a first embodiment of the present invention;

Fig. 4   is a descriptive diagram of the pattern material supply unit of a pattern forming apparatus according to a first embodiment of the present invention;

Fig. 5   is a schematic block diagram of a pattern forming apparatus according to a second embodiment of the present invention;

Fig. 6   is a descriptive diagram of the mask forming unit of a pattern forming apparatus according to a second embodiment of the present invention;

Fig. 7   is a flow chart for describing a pattern forming method according to a first embodiment of the present invention;

Fig. 8   is a flow chart for describing a pattern forming method according to a second embodiment of the present invention;

Fig. 9   is a flow chart for describing a pattern forming method according to a third embodiment of the present invention;

Fig. 10   is a flow chart for describing a pattern forming method according to a fourth embodiment of the present invention;

Fig. 11   is a flow chart for describing a pattern forming method according to a fifth embodiment of the present invention;

Fig. 12   is a flow chart for describing a pattern forming method according to a sixth embodiment of the present invention;

Fig. 13   is a flow chart for describing a pattern forming method according to a seventh embodiment of the present invention;

Fig. 14 is a flow chart for describing a pattern forming method according to a eighth embodiment of the present invention;

Fig. 15 is a flow chart for describing a pattern forming method according to a ninth embodiment of the present invention;

Fig. 16 is a flow chart for describing a pattern forming method according to a tenth embodiment of the present invention;

Fig. 17 is a flow chart for describing a pattern forming method according to an eleventh embodiment of the present invention;

Fig. 18 is a descriptive diagram of a manufacturing process applying a pattern forming method according to the present invention to a semiconductor substrate;

Fig. 19 is a descriptive diagram of a manufacturing process applying a pattern forming method according to the present invention to a semiconductor substrate, showing the steps following those shown in Fig. 18;

Fig. 20 is a descriptive diagram of a manufacturing process applying a pattern forming method according to the present invention to a method for separating devices in a semiconductor device manufacturing process;

Fig. 21 is a descriptive diagram of a manufacturing process applying a pattern forming method according to the present invention to a method for separating devices in a semiconductor device manufacturing process, showing the steps following those shown in Fig. 20;

Fig. 22 is a descriptive diagram of a manufacturing process applying a pattern forming method according to the present invention to a process for forming FET gate electrodes;

Fig. 23 is a descriptive diagram of a manufacturing process applying a pattern forming method according to the present invention to a process for forming FET gate electrodes, showing the steps following those shown in Fig. 22;

Fig. 24 is a descriptive diagram of a manufacturing process applying a pattern forming method according to the present invention to a process for forming contacts between wiring layers;

Fig. 25 is a descriptive diagram of a manufacturing process applying a pattern forming method according to the present invention to a process for forming contacts between wiring layers, showing the steps following those shown in Fig. 24;

Fig. 26 is a descriptive diagram of a manufacturing process applying a pattern forming method according to the present invention to a process for forming contacts between wiring layers, showing the steps following those shown in Fig. 25;

Fig. 27 describes an ITO electrode formation process using a pattern forming method according to the present invention;

Fig. 28 is a describes an ITO electrode formation process using a pattern forming method according to the present invention, showing the steps following those shown in Fig. 27;

Fig. 29 is a descriptive diagram showing the correlation between the surface shape of a pattern coating and the rate of increase in drying temperature;

Fig. 30 is a partial section view showing an example of a microstructure;

Fig. 31 is a partial section view showing another example of a microstructure;

Fig. 32 is a descriptive diagram of an electrode used in a dielectrically processed workpiece;

Fig. 33 is a process diagram showing an example of a conventional pattern forming method; and

Fig. 34 is a process diagram showing an example of a conventional pattern forming method, showing the steps following those shown in Fig. 33.

BEST MODE FOR ACHIEVING THE INVENTION

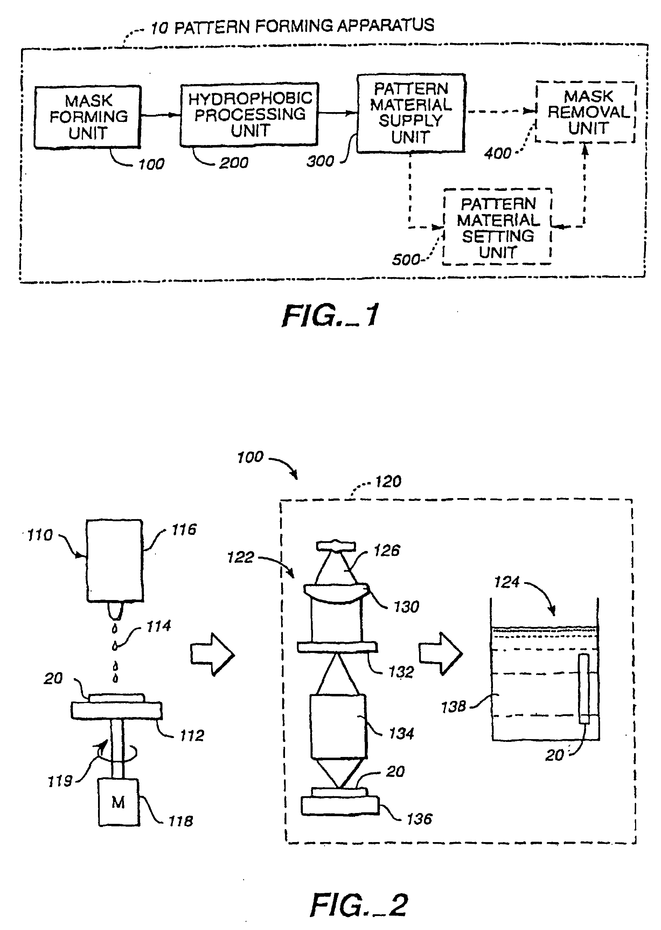

Preferred embodiments of a pattern forming method and apparatus, a semiconductor device, electric circuit, display module, and light emitting device according to the present invention are described in detail with reference to the accompanying figures. Fig. 1 is a schematic block diagram of a pattern forming apparatus according to a first embodiment of the present invention. As shown in Fig. 1, this pattern forming apparatus 10 has a mask forming unit 100 for forming a mask on a surface of a semiconductor substrate or other workpiece, hydrophobic processing unit 200 for making the mask surface hydrophobic, and pattern material supply unit 300 for supplying a liquid pattern material to a pattern forming opening disposed in the mask formed by the mask forming unit 100.

As may be necessary, the pattern forming apparatus 10 can also have a mask removal unit 400 and pattern material setting unit 500 as shown by the dotted line in Fig. 1. This mask removal unit 400 is for removing the mask from the work after the liquid pattern material solidifies. The pattern material setting unit 500 is provided when it is necessary to provide a step for heat solidifying the liquid pattern material.

The mask forming unit 100 in this first embodiment of the invention uses a liquid mask material such as a photoresist as the mask material, and as shown in Fig. 2 has a mask material coating unit 110 and a mask patterning unit 120. The mask material coating unit 110 has a table 112 on which the semiconductor substrate, glass substrate, or other workpiece 20 is placed. The mask material coating unit 110 also has a resist supply unit 116 disposed above the table 112 for depositing or misting the photoresist 114 mask material. The table 112 can also be rotated freely as indicated by arrow 119 by means of motor 118. This enables the mask material coating unit 110 to spin coat the photoresist 114 so as to achieve a resist film (mask material) of uniform thickness.

The mask patterning unit 120 exposes and develops the resist film using a photolithographic technique, and comprises an exposure unit 122 and developer unit 124. The exposure unit 122 has a light source 128 for emitting ultraviolet or other light 126. The light 126 passes lens 130 and is incident to a reticle or other transfer mask 132. After passing the transfer mask 132, the light 126 is collected by a condenser lens 134 and emitted to the workpiece 20 located on the stage 136 to expose the resist film.

After exposing the resist film is completed, the workpiece 20 is immersed in a developer solution 138 in developer unit 124, and the mask is completed by thus forming the openings (trenches) for pattern forming in the resist film, i.e., the mask material. It should be noted that developing can be accomplished in the same way as so-called spin etching. More specifically, the mask can be developed by dripping developer solution 138 onto the spinning workpiece 20 while the workpiece 20 is being rotated. Note, further, that the photoresist 114 can be a negative resist in which the exposed parts are insoluble, or a positive resist in which the exposed parts are soluble.

Furthermore, the mask patterning unit 120 could be configured to write the pattern directly by emitting an electron beam to the resist film.

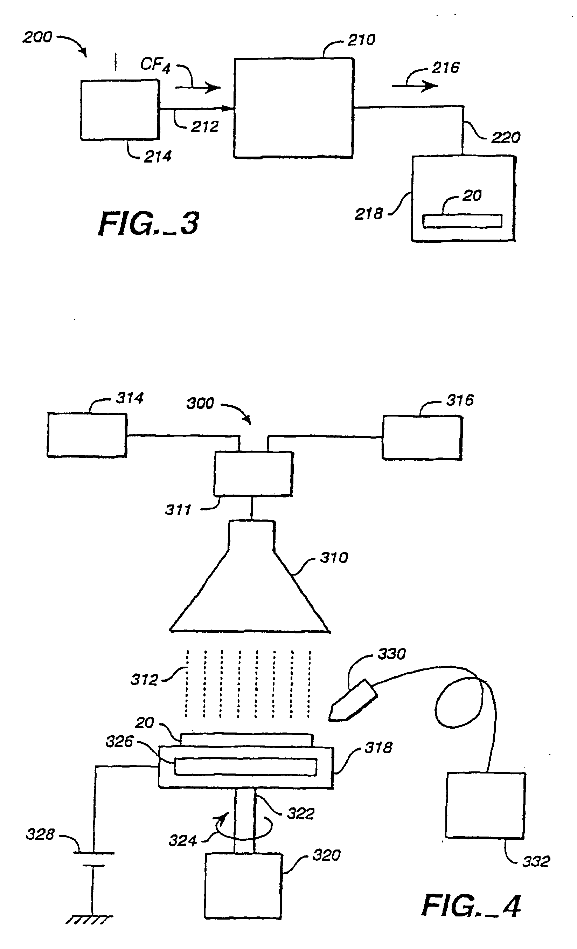

The hydrophobic processing unit 200 is as shown in Fig. 3, for example, having a discharge unit 210. $CF_4$ or other fluorine gas is supplied at atmospheric pressure through supply tube 212 from gas supply source 214 to the discharge unit 210. The discharge unit 210 is a plasma generator, and generates active fluorine such as fluorine ions by discharging an electrical charge in the $CF_4$ gas.

The process gas 216 containing active fluorine generated by the discharge unit 210 is then supplied through process gas line 220 to the process chamber 218 where workpiece 20 is located. The active fluorine in the process gas 216 supplied to the process chamber 218 then fluorinates the surface layer of the resist film formed on the surface of workpiece 20, making it hydrophobic.

It should be noted that if the workpiece 20 is a semiconductor substrate or glass substrate, contact between the process gas and the workpiece 20 exposed through a pattern forming opening in the resist film creates a gas as a result of the reaction

$$Si + 4F \rightarrow SiF_4 \qquad (1)$$

and the workpiece 20 itself is not made hydrophobic. This hydrophobic process can be performed before the resist film is patterned. If the hydrophobic step precedes patterning and the workpiece 20 is made of a material that can be made hydrophobic by the active fluorine, making the workpiece hydrophobic can be avoided and sufficient adhesion of the formed pattern can be assured without applying a hydrophilic process after the hydrophobic process.

The hydrophobic process could alternatively form a hydrophobic polymer film (a fluoropolymer film, for example) further described below on the surface of the resist film. In this case the hydrophobic film formed inside the pattern forming openings of the workpiece 20 is preferably made hydrophilic and eliminated by exposure to ultraviolet light, electron beams, or other electromagnetic wave or radiation beam.

As shown in Fig. 4, the pattern material supply unit 300 has an atomizer 311 for atomizing the liquid pattern material, and a shower head 310 for misting the liquid pattern material 312 atomized by the atomizer 311. In this preferred embodiment an atomizer 311 that can atomize the liquid pattern material 312 to a particle diameter of approximately 0.2 μm in order to form micropatterns with a line width of 1 μm or less on the workpiece 20 is used. A microparticle liquid such as this can be produced using an atomizer from Primaxx, Inc, of the United States.

A liquid pattern material source 314 and mist gas source 316 are connected to the atomizer 311. The liquid pattern material source 314 supplies an organometallic solution or other liquid pattern material 312 to the atomizer 311. The mist gas source 316 also supplies nitrogen or other high pressure, inert gas to the atomizer 311. The atomizer 311 then discharges the high pressure gas and liquid pattern material 312 to make a particle mist from liquid pattern material 312 and sprays the particle mist from shower head 310. The particles in the misted liquid pattern material 312 are positively and negatively charged as known from the literature.

A process stage 318 with a workpiece 20 having a mask on the surface thereof placed on the process stage 318 is disposed below the shower head 310. The process stage 318 is mounted on the rotating shaft 322 of a motor 320, that is, a rotating means, and rotates freely in the direction of arrow 324. By thus rotating the process stage 318, the pattern material supply unit 300 of this embodiment can easily supply liquid pattern material 312 to the pattern forming openings in the mask, and unneeded liquid pattern material 312 adhering to the mask surface can be removed.

The process stage 318 also has an internal heater 326, that is, a heating means, for drying or heat setting the liquid pattern material 312 supplied to the pattern forming openings (pattern forming recesses) disposed in the mask. The process stage 318 is further connected to a dc power supply 328 via a sliding contact, for example, not shown in the figures.

The dc power supply 328 is a voltage applying means, and applies a positive dc voltage to the workpiece 20 by way of process stage 318. As a result, the particles of liquid pattern material 312 negatively charged when misted from the shower head 310 are attracted to the workpiece 20 by the static attraction of the positive dc voltage applied to the workpiece 20, and thus adhere to the workpiece 20. Therefore, not only can particles of the liquid pattern material 312 thus be efficiently and quickly supplied to the pattern forming openings in the mask, the liquid pattern material 312 can be reliably supplied to the pattern forming openings even when the liquid pattern material 312 is supplied as free particles suspended in air.

The pattern material supply unit 300 of this embodiment has an air knife 330, that is, an adherent liquid removal means. This air knife 330 discharges compressed air from a compressed air source 332 to remove unneeded liquid pattern material 312 adhering to the mask surface (top surface) when the liquid pattern material 312 is supplied to the pattern forming openings.

It should be noted that the adherent liquid removal means could be the motor 320. More specifically, liquid pattern material 312 adhering to the mask surface can be removed by centrifugal force by increasing the speed of the motor 320. The adherent liquid removal means could also be comprised with a cylinder, for example, for tilting the base, not shown in the figures, on which the motor 320 and process stage 318 are disposed to incline the workpiece 20 by way of the intervening base so that the liquid pattern material 312 adhering to the hydrophobic treated surface of the mask rolls off.

It will also be noted that the pattern material supply unit 300 could be a discharge device such as the print head of an inkjet printer, for example, configured to selectively supply the liquid pattern material 312 to the pattern forming recesses. The liquid pattern material 312 can be prevented from adhering to the mask surface, and steps for removing the unnecessary adherent liquid or removing the solidified liquid pattern material adhering to the mask surface as described below can be omitted, by thus selectively supplying the liquid pattern material 312 to the openings. The pattern material supply unit 300 could also be comprised to drip the liquid pattern material onto the rotating workpiece 20 to deposit the pattern material into the pattern forming openings by spin coating.

The mask removal unit 400 has a mask removal tank (not shown in the figure) containing an organic solvent able to dissolve the mask resist film, ozonated water or other functional solution. Of course the mask removal unit 400 could be comprised with a discharge unit for ashing the resist film by generating plasma from oxygen or ozone at atmospheric pressure, activating oxygen or ozone by exposure to a laser beam or electron bean to ash the resist film by means of the active oxygen atoms, or ashing in a supercritical fluid. The mask removal unit 400 could also be disposed with a CMP (chemical mechanical polishing) unit, a spin etching unit, or other device for easily removing solidified liquid pattern material 312 adhering to the mask surface.

The pattern material setting unit 500 can be comprised as a heating chamber or as a tunnel oven (neither shown in the figures) having a heater as a heating means for heating and solidifying the liquid pattern material 312 in the pattern forming openings. The pattern material setting unit 500 could also be configured to solidify the liquid pattern material 312 using an infrared heater or laser beam or electron beam emissions. The liquid pattern material 312 is preferably set in an inert atmosphere of, for example, nitrogen. By placing the pattern material in an inert atmosphere, oxidizing the pattern can be prevented even when the pattern is formed using an easily oxidized metal, and deterioration of electrical characteristics can thus be prevented.

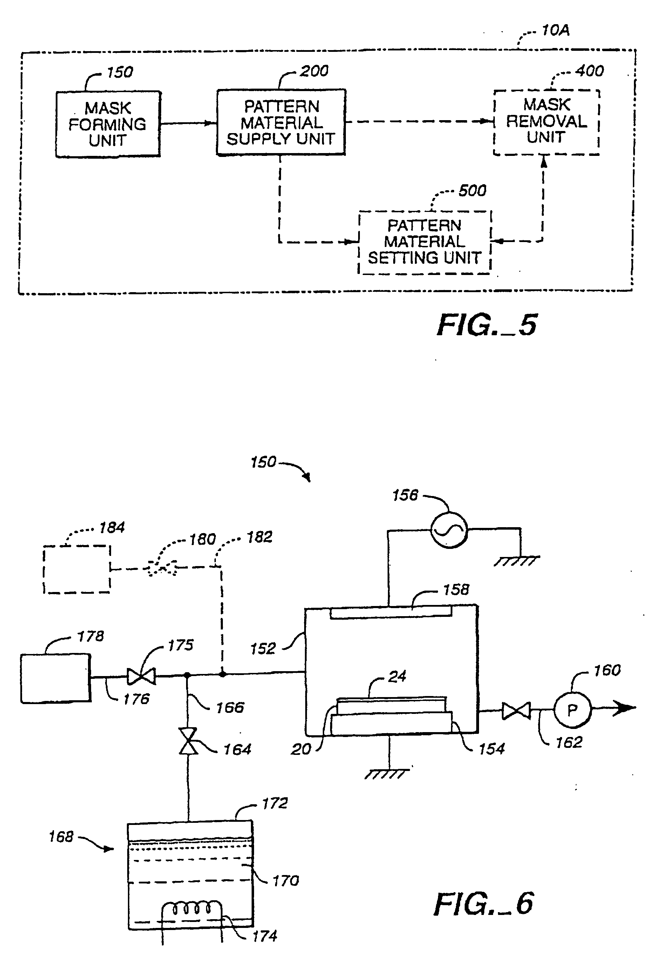

Fig. 5 is a schematic block diagram of a pattern forming apparatus according to a second embodiment of the present invention. This pattern forming apparatus 10A has a mask forming unit 150 and pattern material supply unit 200. The pattern forming apparatus 10A of this second embodiment, however, does not have a hydrophobic processing unit as disposed in the pattern forming apparatus 10 of the first embodiment. This pattern forming apparatus 10A also has a mask removal unit 400 and pattern material setting unit 500 as necessary.

The mask forming unit 150 of the pattern forming apparatus 10A according to this second embodiment is as shown in Fig. 6 and can form a mask from a hydrophobic film.

As shown in Fig. 6 the mask forming unit 150 has a film processing chamber 152, and the semiconductor substrate, glass substrate, or other workpiece 20 is placed on a film formation stage 154 disposed inside the film processing chamber 152. The film processing chamber 152 also has a high frequency electrode 158 connected to a high frequency power source 156 above the film formation stage 154. The film formation stage 154 is the ground electrode so that a high frequency voltage can be applied between the film formation stage 154 and high frequency electrode 158.

A metal transfer mask 24, for example, is removably disposed on top of the workpiece 20. The transfer mask 24 covers the parts corresponding to the pattern forming openings in the hydrophobic mask described below, and has openings in those parts corresponding to the parts other than the pattern forming openings. The film formation stage 154 also has a cooling section (not shown in the figure) such as a cooling coil for cooling the workpiece 20 placed on the top thereof to promote formation of a polymer film.

A vacuum pump 160 is connected to the film processing chamber 152 via an exhaust pipe 162 for reducing the internal pressure. A film formation material supply unit 168 is also connected to the film processing chamber 152 via a supply line 166 with a flow control valve 164. This film formation material supply unit 168 has a container 172 for storing a liquid fluorocompound 170 such as $C_4F_{10}$, $C_8F_{18}$, or other straight chain PFC. A heater 174 is disposed in the container 172 as a heating unit for heating and vaporizing the liquid fluorocompound 170. A carrier gas supply unit 178 is connected to the downstream side of the flow control valve 164 in supply line 166 by way of intervening carrier line 176 equipped with a flow control valve 175. Nitrogen, argon, or other inert gas is used for the carrier gas. Argon, which can easily be made to discharge, is preferable.

When forming the mask with this mask forming unit 150, the workpiece 20 having the transfer mask 24 placed thereon is placed on the film formation stage 154. The pressure inside the film processing chamber 152 is then reduced by the vacuum pump 160, and the liquid fluorocompound 170 vapor is introduced with the carrier gas to the film processing chamber 152. A high frequency voltage is then applied by the high frequency power source 156 between the high frequency electrode 158 and film formation stage 154, generating a vapor discharge and ionizing the liquid fluorocompound 170 vapor.

The ionized liquid fluorocompound 170 thus polymerizes on the top of the workpiece 20 and transfer mask 24, forming a hydrophobic fluoropolymer film. That is, because the pattern forming recess parts of the workpiece 20 are covered by the transfer mask 24, the hydrophobic fluoropolymer film is formed on the parts other than the parts corresponding to the pattern forming recesses. After completing formation of the polymer film for a specified time, the workpiece 20 is removed from the film processing chamber 152 and the transfer mask 24 is removed from the workpiece 20 to obtain a workpiece 20 having a mask comprising a hydrophobic film in which pattern forming openings are formed. It is therefore not necessary with the pattern forming apparatus 10A of this second embodiment to process the mask for hydrophobic. The workpiece 20 on which a mask has been formed in the mask forming unit 150 is then conveyed directly to the pattern material supply unit 300, and liquid pattern material 312 is supplied to the pattern forming openings of the mask in the same way as described above.

It should be noted that as indicated by the dotted lines in Fig. 6 an additive gas supply unit 184 can be connected to the supply line 166 through an intervening line 182 having a flow control valve 180. In this case $CF_4$ can be added to the liquid fluorocompound 170 vapor as a gas additive from the additive gas supply unit 184. Plasma is then generated from the mixture of $CF_4$ and liquid fluorocompound 170 in the film processing chamber 152. The fluorine in the additive gas is thus activated and the active fluorine is included in the polymer film when the liquid fluorocompound 170 is polymerized, thereby improving the hydrophobic of the polymer film.

The mask can alternatively be formed by forming a fluoropolymer film on the workpiece 20, and then exposing this polymer film to a beam of ultraviolet light or an electron beam to breakdown and remove part of and pattern the fluoropolymer film. The mask can also be achieved with the mask forming unit 100 shown in Fig. 2 when it is formed from a hydrophobic film. That is, a hydrophobic resist film such as a fluororesin photoresist can be applied to the workpiece 20 and dried using the mask material coating unit 110, and the pattern forming openings then formed using the mask patterning unit 120 to form the mask.

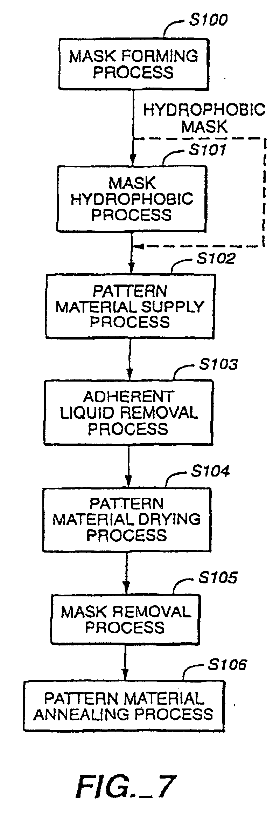

Fig. 7 is descriptive diagram of a third embodiment of the present invention, and is a process flow chart of a first pattern forming method. As shown in step S100 in Fig. 1, this first pattern forming method first forms a mask having pattern forming openings on the surface of the workpiece. This mask forming step S100 is accomplished by the mask forming unit 100 shown in Fig. 1. More specifically, the workpiece 20 is conveyed into the mask material coating unit 110 shown in Fig. 2 of the mask forming unit 100. The photoresist 114 is then coated to and dried on the surface of the workpiece 20 by the mask material coating unit 110.

The workpiece 20 is then conveyed to the mask patterning unit 120. The mask material, that is, resist film, is then exposed in the exposure unit 122 of the mask patterning unit 120 and developed in the developer unit 124. A mask having pattern forming openings in the resist film is thus formed on the surface of the workpiece 20. It should be noted that the pattern forming openings could be written directly in the resist film using an electron beam or laser.

The surface of the mask is then processed for hydrophobic in the hydrophobic processing unit 200 (step S101). This mask hydrophobic process can be accomplished by generating active fluorine in the discharge unit 210 shown in Fig. 3 and supplying the active fluorine to the process chamber 218 in which the workpiece 20 is placed. It will also be noted that this workpiece surface hydrophobic process could be accomplished using an apparatus as shown in Fig. 6 to form a hydrophobic film such as a fluoropolymer film or silicon polymer film on the mask surface. When a hydrophobic process is applied according to the method shown in Fig. 3, the hydrophobic film present in the pattern forming openings is preferably removed or made hydrophilic using ultraviolet light, an electron beam, or laser, for example. Yet further, if the mask is formed by a hydrophobic film by means of mask forming unit 150 as shown in Fig. 5 or Fig. 6, the hydrophobic mask processing step can be omitted as indicated by the dotted line in Fig. 7.

As shown in step S102, a pattern material supply step is executed to supply liquid pattern material 312 to the pattern forming openings in the mask. This pattern material supply step is accomplished by the pattern material supply unit 300 shown in Fig. 4. More specifically, while the motor 320 rotates the workpiece 20 by way of process stage 318, the liquid pattern material 312 is converted to a particle mist by the atomizer 311, the particles are discharged from the shower head 310, and the discharged mist particles then adhere to the workpiece 20, which is charged with a dc voltage by the dc power supply 328, due to static attraction.

By thus supplying the liquid pattern material 312 while turning the workpiece, the liquid pattern material 312 dripped onto the surface of the hydrophobic mask is moved across the mask surface by centrifugal force and easily penetrates the pattern forming openings. The pattern material can therefore be quickly supplied and the liquid pattern material 312 can be evenly supplied to each of the pattern forming openings, making it possible to form a pattern with a uniform thickness (height).

It will be noted that supplying the liquid pattern material 312 to the pattern forming openings of the mask formed on the workpiece 20 can be done by spin coating the liquid pattern material 312, or by using a specific-volume discharge device such as the print head of an inkjet printer.

Once the liquid pattern material 312 is supplied to the pattern forming openings, compressed air is discharged from the air knife 330 in an adherent liquid removal step for removing the liquid pattern material adhering to the mask surface (step S103). However, this adherent liquid removal step could alternatively be accomplished by spinning the workpiece 20 at high speed by means of the motor 320 shown in Fig. 4 to remove the liquid pattern material 312 adhering to the mask surface by means of centrifugal force, or by tilting the workpiece 20. Yet further, the adherent liquid removal step could be accomplished by operating the air knife 330 while spinning the workpiece 20 or inclining the workpiece 20.

Unnecessary pattern material can thus be easily removed by removing liquid pattern material 312 adhering to the mask surface at the stage at which the liquid pattern material is supplied to the pattern forming openings. It is therefore possible to eliminate a step for removing solidified pattern material that is difficult to remove after the liquid pattern material is solidified in a drying process, described below, and the mask can therefore be easily removed. Note that when the liquid pattern material is supplied directly to the pattern forming openings by the above-noted specific-volume discharge device, the adherent liquid removal step of step S103 can be omitted.

The liquid pattern material 312 supplied to the pattern forming openings is then dried (step S104). Evaporating solvent contained in the liquid pattern material 312 is the main objective of drying the liquid pattern material 312, and is normally achieved by heating the workpiece 20 to 80° to 120° C. The workpiece drying process can be accomplished using the heater 326 built in to the process table 318 shown in Fig. 4, or with a tunnel oven, infrared heater, or laser, not shown in the figures. The pattern material drying step is also preferably performed in an inert atmosphere, such as a nitrogen atmosphere, to prevent pattern oxidation. Of course, the drying step could be performed in an oxidizing atmosphere if oxidizing the pattern is not a problem or if oxidation is preferable.

A mask removal step is performed next (step S105). This mask removal step can be accomplished by immersing the workpiece 20 in a solution able to dissolve the resist film similarly to a conventional semiconductor device manufacturing process. The mask removal step can alternatively be accomplished immersing the workpiece 20 in ozonated water or other functional solution, or by ashing a mask made from a resist film using a supercritical fluid. Moreover, the mask removal step could drip a resist removal fluid onto the spinning workpiece 20 while the workpiece 20 is rotated as in a spin etching process. Yet further, the mask removal step could be accomplished by ashing with active oxygen generated by emitting an ultraviolet beam or electron beam into oxygen or ozone, or by an electrical discharge into oxygen or ozone at atmospheric pressure.

After removing the mask, solute contained in the liquid pattern material supplied to the pattern forming openings is annealed in the pattern material setting unit 500 shown in Fig. 1 to complete the solute solidification process (step S106). This pattern annealing step is normally conducted by heating the workpiece 20 to a higher temperature, such as 150°C or higher, than used in the pattern drying process.

It is thus possible to form a specifically detailed pattern on the surface of the workpiece 20. Moreover, because the liquid pattern material 312 is annealed in the pattern annealing process after drying in the pattern drying process in this first pattern forming method, the formation of internal voids and the formation of deformation recesses in the formed pattern surface when the liquid pattern material 312 solidifies can be prevented.

Note that like the pattern drying process the pattern annealing process preferably occurs in an inert atmosphere. Furthermore, the pattern annealing step shown as step S106 can be omitted if the liquid pattern material 312 enables the solute solidification reaction to be sufficiently advanced in the pattern drying process of step S104, or if the workpiece 20 can be heated in the drying process of step S104 to a high temperature equivalent to the annealing temperature of the pattern annealing process.

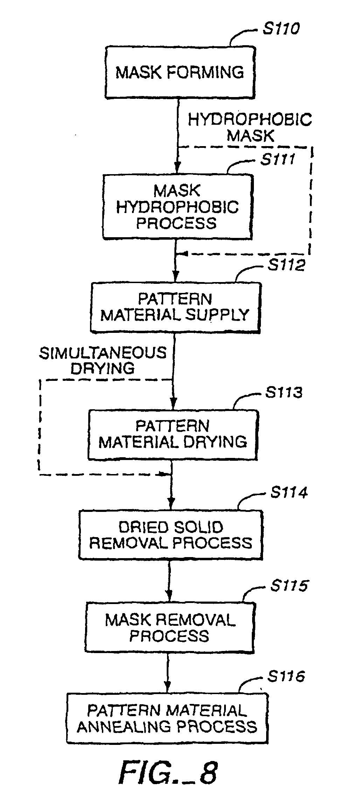

Fig. 8 is a flow chart of a second pattern forming method according to the present invention. This second pattern forming method first forms a mask on the surface of the workpiece 20 as shown in step S110. The mask hydrophobic process (step S111) and pattern material supply process (step S112) for supplying the liquid pattern material to the pattern forming openings in the mask are then sequentially performed. The mask forming process, mask hydrophobic process, and pattern material supply process are the same as in the first pattern forming method described above. When the mask is formed from a hydrophobic film, the mask hydrophobic process in step S111 can be omitted.

The liquid pattern material 312 supplied to the pattern forming openings of the mask is then dried (step S113). This drying process is also as described above. Then, once the drying process is completed, the dried solids (not shown in the figure) from the liquid pattern material 312 adhering to the mask surface are removed. Removing the dried solids can be accomplished by immersing the workpiece 20 in an etching solution capable of removing the dried solids, spin etching using an etching solution, CMP, or other method.

It should be noted that if the workpiece 20 is heated by heater 326 built in to the process table 318 when the liquid pattern material 312 is supplied to the pattern forming openings using shower head 310 shown in Fig. 4 so that the pattern material is supplied and dried at the same time, the drying process shown as step S113 can be omitted as indicated by the dotted line in Fig. 8.

As in the first embodiment of a pattern forming method described above, a mask removal process (step S115) and pattern annealing process in step S116 are applied in order. These steps are also the same as in the previous embodiment.

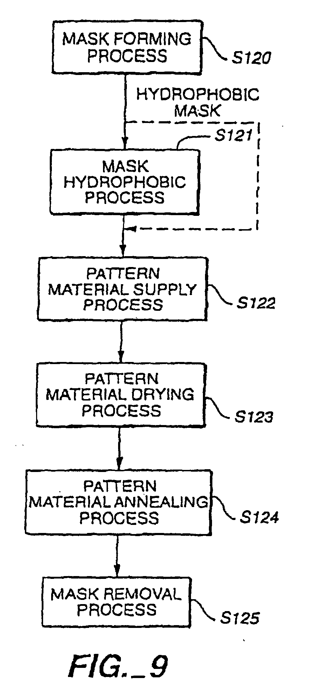

Fig. 9 is a flow chart of a third pattern forming method according to the present invention. After forming a mask on the surface of the workpiece 20 as indicated by step S120, the pattern forming method according to this embodiment hydrophobic processes the mask surface (step S121) and then runs the pattern material supply process (step S122) to supply the liquid pattern material 312 to the pattern forming openings formed in the mask. These steps S120 to S122 are the same as described above. When the mask is formed from a hydrophobic film, the mask hydrophobic process in step S121 can be omitted.

The pattern drying process of step S123, which is a pattern material heating and solidification process, and the pattern annealing process (anneal process) of step S124, are then performed. The pattern material drying process heats the workpiece 20 to 80° to 120°C, for example, to vaporize solvent in the liquid pattern material supplied to the pattern forming openings. The pattern annealing process normally uses a temperature above that of the drying process, heating the workpiece 20 to a temperature, such as 150° to 220°C, that will not carbonize a mask made from a resist film, heating solute contained in the liquid pattern material 312 to a higher temperature and completing the solidification reaction. The drying and annealing processes can be accomplished by the heater 326 shown in Fig. 4, or by introduction to the special pattern material setting unit 500 shown in Fig. 1. To prevent oxidation of the pattern material, the drying and annealing processes are preferably accomplished in an inert atmosphere such as nitrogen.

By thus separating the pattern material drying process and the pattern annealing process, a pattern with a good shape can be achieved from the liquid pattern material 312 supplied to the pattern forming openings. More specifically, if the liquid pattern material is rapidly heated to a high temperature, recesses form in the surface of the solidified pattern and the shape of the pattern is not good. As a result, when a good pattern configuration is required in this case, it is necessary to adjust the shape of the pattern by means of CMP or other technique after the liquid pattern material is rapidly heated to form the pattern and the mask is removed.

It should be noted that if the liquid pattern material 312 solidifies sufficiently at the normal drying temperature, the pattern annealing process of step S124 can be omitted. In addition, the drying process of step S123 can be omitted if heating and solidifying the liquid pattern material 312 at a high temperature from the beginning poses no problem.

Once annealing the pattern material is completed, the mask is removed in the mask removal unit 400 as shown in step S125. If solids from the liquid pattern material adhering to the mask surface are present, the solids are first removed by CMP, etching, or other method in this mask removal process, and the mask is then removed. The mask can be removed as described above.

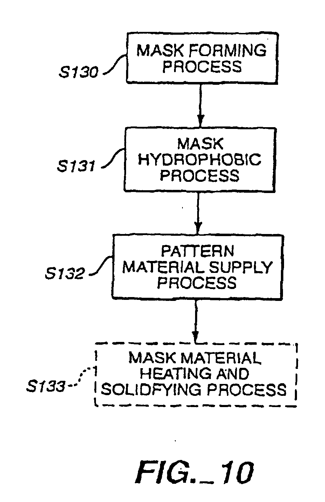

It should be noted that the mask forming process and mask removal process in the pattern forming methods of the above-described embodiments can be omitted when forming a wiring pattern in a semiconductor substrate, for example, if pattern forming recesses are already formed in a film comprising a dielectric material such as an oxide film on the surface of a semiconductor substrate, and the wiring pattern is formed by supplying a liquid pattern material 312 comprising an organometallic compound solution to the pattern forming openings in the dielectric film. A workpiece hydrophobic process is then applied instead of the mask hydrophobic process. Furthermore, the adherent liquid removal process and dried solid removal process are unnecessary, and process steps can therefore be simplified, if the print head of an inkjet head or other such discharge device is used to selectively supply liquid pattern material 312 to the pattern forming openings in the mask so that the liquid pattern material 312 does not adhere to the mask surface. Fig. 10 is a flow chart of a pattern forming method for this case.

As shown in step S130 in Fig. 10, this fourth pattern forming method forms a mask on the surface of a semiconductor substrate, that is, workpiece 20. The mask is formed here by, for example, coating a mask material able to form a film of silicon dioxide ($SiO_2$) on the surface of the workpiece 20, and patterning the same to form a mask having pattern forming openings corresponding to the wiring pattern.

A mask hydrophobic process is then applied (step S131). This hydrophobic process is accomplished by forming, for example, a fluoropolymer film on the mask. Polymer film in the pattern forming openings is then removed in this hydrophobic process to expose the surface of the workpiece (semiconductor substrate) 20.

Next, a liquid pattern material 312 comprising an organometallic compound is supplied by a specific-volume discharge device such as the print head of an inkjet printer to the pattern forming openings in the mask processed for hydrophobic as described above. By heating the workpiece 20 to a specific temperature by means of a heater built in to the table on which the workpiece 20 is placed, supplying the liquid pattern material 312 to the openings and heating and solidifying the liquid pattern material are performed at the same time, and the pattern forming process ends with step S132.

The pattern material heating and solidifying process can, of course, be separated from the pattern material supplying process as indicated by the dotted line step S133 in Fig. 10. In addition, this heating and solidifying process can comprise a drying step and an annealing step, and heating and solidifying can be accomplished at a constant temperature.

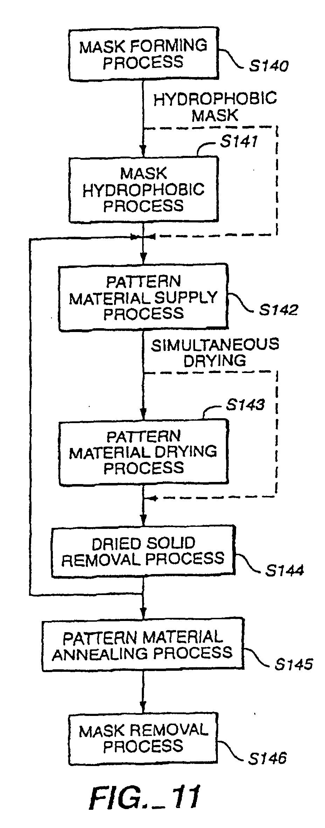

Fig. 11 is a flow chart of a fifth pattern forming method according to the present invention. The pattern forming method according to this embodiment performs the pattern material supplying process plural times in order to achieve a pattern with a good shape and a detailed pattern.

As in the embodiments described above, a mask is first formed on the surface of the workpiece 20 (step S140) and the mask surface is then processed for hydrophobic (step S141). These steps can be the same as described above. Furthermore, if the mask is made from a hydrophobic film such as a fluororesin polymer film, the hydrophobic process of step S141 can be omitted as indicated by the dotted line.

Next, liquid pattern material 312 is supplied to the pattern forming openings of the mask as described above in the pattern material supply process of step S142. Supplying the liquid pattern material 312 to the openings in this step is limited in this embodiment to some fraction of the total required amount. When the first pattern material supply process is completed, the pattern material drying process is applied to evaporate the solvent in the liquid pattern material (step S143). Note that the pattern material drying process can be omitted as indicated by the dotted line if in the pattern material supply process the liquid pattern material 312 is supplied to the pattern forming openings while heating the workpiece to an appropriate temperature.

Dried solids of the liquid pattern material 312 adhering to the mask surface are then removed as shown by step S144. The dried solids can also be removed as described above. Once the dried solids are removed, the process returns to step S142 and steps S142 to S144 are repeated the required number of times. Once the last pattern material supply process, pattern material drying process, and dried solid removal process are completed, processing moves to the pattern annealing process shown in the next step S145 to anneal solutes contained in the liquid pattern material 312, complete the solidification reaction, and remove the mask as described above (step S146).

By thus supplying the liquid pattern material 312 to the pattern forming openings in the mask plural times in this fifth pattern forming method, the shape of the completed pattern can be made extremely good and a finely detailed pattern can be formed. In addition, because the dried solids are removed each time the liquid pattern material 312 is dried, removing the solids is relatively easy compared with removing the solids after annealing.

It should be noted that when the liquid pattern material 312 is supplied to the openings plural times, the second and subsequent pattern material supply processes (step S142) can as necessary be applied after the pattern material drying process in step S143, or after annealing the pattern material in step S145.

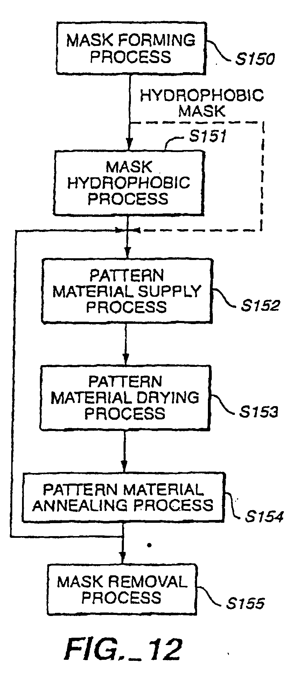

Fig. 12 is a flow chart of a sixth pattern forming method according to the present invention. This pattern forming method sequentially performs the mask forming process (step S150), mask hydrophobic process (step S151), and pattern material supply process (step S152) using the same methods as in the above described embodiments.

The liquid pattern material 312 supplied to the pattern forming openings is then dried and annealed as the heating and solidifying process (steps S153, S154). When this annealing process is completed, the process returns to step S152 to complete a second pattern material supply process, and the drying process and annealing process of steps S153 and S154 are then executed. These steps S152 to S154 are repeated as many times as necessary. When the last pattern annealing process is completed, the mask is removed as described above (step S155).

It should be noted that when the liquid pattern material is supplied to the pattern forming openings by spin coating or the pattern material supply unit 300 shown in Fig. 4, solids of the liquid pattern material 312 adhering to the mask surface are removed by CMP, for example, in the mask removal process of step S155, and the mask is then removed. Furthermore, removing the solids is not necessary if the liquid pattern material 312 is selectively supplied to the pattern forming openings by a discharge device such as the print head of an inkjet printer so that the liquid pattern material does not adhere to the mask surface.

Furthermore, the second and subsequent times the pattern material supply process of step S152 is performed, it can as necessary be applied after the pattern material drying process of step S153. In addition, if the liquid pattern material 312 solidifies sufficiently at a relatively low temperature, the pattern annealing process can be omitted, and if the pattern material can be processed at a high temperature from the beginning, the pattern drying process can be omitted.

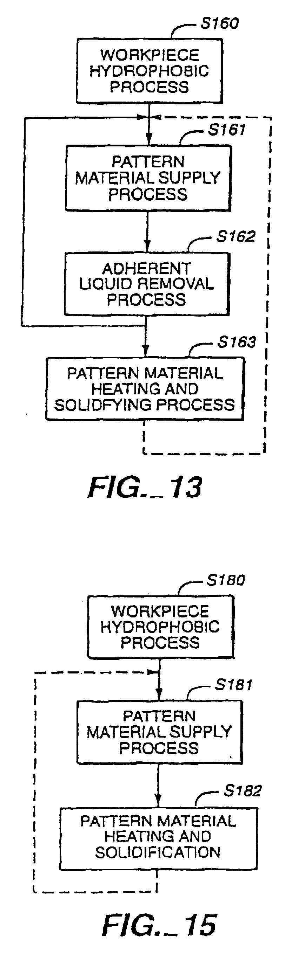

Fig. 13 is a flow chart of a seventh pattern forming method according to the present invention. The pattern forming method of this embodiment is used when pattern forming openings are already disposed on the surface of the workpiece 20, such as in combination with conventional processes. The mask forming process is therefore omitted in this seventh pattern forming method.

More specifically, the pattern forming method shown in Fig. 13 starts with hydrophobic processing the workpiece surface (step S160). As described above, this hydrophobic process forms a hydrophobic film by fluorination with active fluorine or by forming a fluoropolymer film, for example. A hydrophilic process is then applied to the bottom of the pattern forming openings in this workpiece hydrophobic process by emitting an ultraviolet beam or electron beam to the pattern forming openings as necessary. This hydrophilic process includes the breakdown and removal of the formed hydrophobic film by means of ultraviolet light or electron beam instead of just simply imparting hydrophilic by removing fluorine adhering to the workpiece 20 or reacting with the workpiece 20. Pattern adhesion can be improved when the liquid pattern material supplied to the pattern forming openings solidifies by thus imparting hydrophilic. It is therefore possible to achieve good electrical conductivity and achieve excellent electrical characteristics when an electrical connection is required between the formed pattern and the workpiece.

When processing the workpiece 20 for hydrophobic is completed, the pattern material supply process for supplying a specific amount of liquid pattern material 312 to the pattern forming recesses is executed (step S161). Supplying the liquid pattern material 312 to the recesses in this pattern material supplying process can be accomplished as described above. When supplying the liquid pattern material to the pattern forming recesses is completed, the adherent liquid removal process of step S162 is executed. In other words, liquid pattern material 312 adhering to the surface of the workpiece 20 is removed. Removing liquid pattern material 312 adhering to the workpiece 20 surface can be accomplished as described above using an air knife 330 shown in Fig. 4, or by rotating or inclining the workpiece 20.

The pattern material supply process in step S160 and the adherent liquid removal process of step S162 can be repeated as many times needed. Once steps S161 and S162 have been repeated the necessary number of times, the pattern forming process is completed by heating and solidifying the liquid pattern material 312 supplied to the pattern forming recesses (step S163).

The heating temperature of the pattern material in the pattern material heating and solidifying process of step S163 differs according to the liquid pattern material 312, and there are cases in which the heating and solidifying temperature is approximately 80° to 120°C and does not different much from the drying temperature, and cases in which it is necessary to heat to the annealing temperature of 200°C or higher. As may be necessary, the pattern material heating and solidifying process can also contain a drying process for evaporating solvent in the liquid pattern material 312 and an annealing process for annealing the dried solute.

It should be noted that if the surface of the workpiece 20 is already hydrophobic, the workpiece hydrophobic process of step S160 can be omitted. As indicated by the dotted line in Fig. 13, the adherent liquid removal process of step S162 and the pattern material heating and solidifying process of step S163 can be applied when the liquid pattern material 312 is supplied to the pattern forming recesses, and the next pattern material supply process executed as soon as the pattern material heating and solidifying process ends. If the pattern material supply process is thus executed after the heating and solidifying process ends, a fine pattern with extremely low internal stress can be formed.

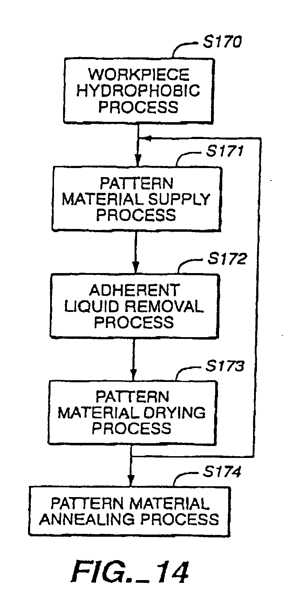

Fig. 14 is a flow chart of an eighth pattern forming method according to the present invention. The pattern forming method of this embodiment is also applied when pattern forming recesses are also disposed to the workpiece 20. This eighth pattern forming method first hydrophobic processes the surface of the workpiece 20 (step S170). This workpiece 20 hydrophobic process is as described previously.

Then, in the pattern material supply process, a specific amount of liquid pattern material 312 is supplied to the pattern forming recesses disposed to the workpiece 20 (step S171). The adherent liquid removal process for removing the liquid pattern material 312 adhering to the workpiece surface is then applied as shown in step S172. After unneeded pattern material is removed, the workpiece 20 is heated to a specific temperature (80° to 120°C, for example) to dry liquid pattern material 312 supplied to the workpiece 20 recesses (step S173).

The process then returns to step S171 to run the pattern material supply process and again supply the liquid pattern material 312 to the pattern forming recesses in which dried solid pattern material is present, and then repeat steps S172 and S173. These steps S171 to S173 are repeated as many times as necessary. When the last pattern material supply process, adherent liquid removal process, and pattern material drying process are completed, dried solid solute in the liquid pattern material 312 is annealed at high temperature to complete the solidification reaction.

By thus supplying the liquid pattern material to the pattern forming recesses a small amount at a time, and repeating the pattern material supply and pattern material drying steps, the formation of voids when the pattern material dries can be prevented, and a detailed pattern with low internal stress can be formed. Moreover, because unnecessary liquid pattern material adhering to the workpiece surface is removed before drying the liquid pattern material 312, excess material adhering to the workpiece 20 surface can be removed more easily than when dried material is removed.

It will also be obvious that a pattern can be formed by applying the processes from step S171 to S174 only once.

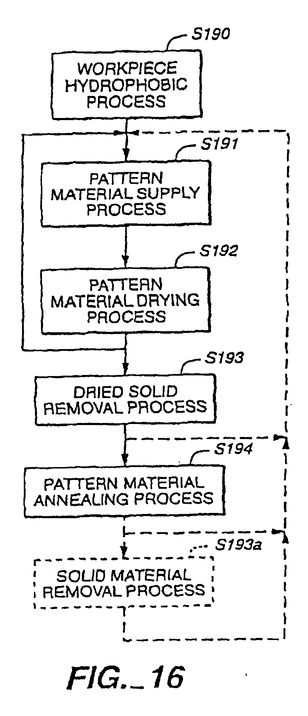

Fig. 15 is a flow chart of a ninth pattern forming method according to the present invention. This ninth pattern forming method first hydrophobic processes the surface of the workpiece 20 in which pattern forming recesses are also formed (step S180). Then using a discharge device such as the print head of an inkjet printer, a specific amount of liquid pattern material 312 is selectively supplied to the pattern forming recesses of the workpiece 20 (step S181). The liquid pattern material 312 is then heated and solidified (step S182) to complete pattern forming. Heating and solidifying the pattern material can be done at a relatively low temperature of 120°C or less as described above, or at a higher temperature. Pattern heating and solidifying can also contain a process for drying the liquid pattern material and a subsequent annealing process.

By thus selectively supplying the liquid pattern material 312 to the pattern forming recesses of the workpiece 20 by means of a discharge device in this ninth pattern forming method, it is not necessary to provide a step for removing material adhering to the workpiece surface, and processing can be simplified.

It should be noted that as indicated by the dotted line in Fig. 15, the pattern material supply process of step S181 and the pattern material heating and solidifying process of step S182 are repeated once heating and solidifying the liquid pattern material 312 supplied to the pattern forming recesses ends. Pattern forming ends when the pattern material supply process and pattern material heating and solidifying process have been repeated the necessary number of times.

Fig. 16 is a flow chart of a tenth pattern forming method according to the present invention. As described above, the pattern forming method of this embodiment first hydrophobic processes the surface of the workpiece 20 in which pattern forming recesses are also formed (step S190). A specific amount of liquid pattern material 312 is then supplied to the pattern forming recesses (step S191). Next, the liquid pattern material 312 supplied to the pattern forming recesses of the workpiece 20 is dried (step S191). When drying the pattern material is completed, processing returns to step S191 to supply liquid pattern material 312 to the recesses again, and the pattern material drying process of step S192 is accomplished. This pattern material supply process and pattern material drying process are repeated as many times necessary.

When the last pattern material supply process and pattern material drying process end, dried solids of the liquid pattern material 312 adhering to the workpiece surface are removed by CMP, plasma etching at atmospheric pressure, or other technique (step S193). After removing the dried solids is completed, solutes contained in the liquid pattern material 312 are annealed in the pattern material annealing process as shown in step S194.

It should be noted that as indicated by the dotted line in Fig. 16, the second and subsequent pattern material supply processes can be performed after the dried solid removal process of step S193, or after the pattern material annealing process of step S194. Furthermore, the pattern material solidifying process of step S194 can be applied after the pattern material drying process of step S192 without performing the dried solid removal process of step S193, and the solid removal process then applied as indicated by the dotted line step S193a in Fig. 16. By thus performing the solid removal process of step S193a after the pattern material solidifying process of step S194, removing the solids can be completed in one step and the process can thus be simplified. It is, of course, also possible to apply the solid removal process after the pattern material annealing process, then return to step S191 and repeat step S191, step S192, step S194, and step S193a the necessary number of times.

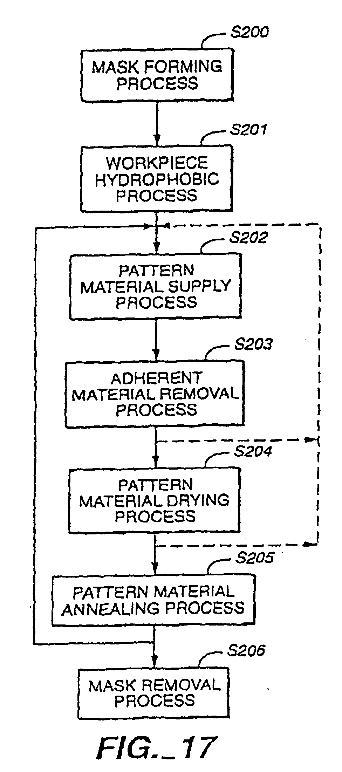

Fig. 17 is a flow chart of an eleventh pattern forming method according to the present invention. This eleventh pattern forming method is one pattern forming method applied when pattern forming recesses are not disposed to the workpiece 20.

This method first forms a mask on the workpiece 20 surface in the same way as previously described step S200), and the mask hydrophobic process is then applied (step S201). Next, after supplying the liquid pattern material 312 to the pattern forming openings formed in the mask (step S202), the adherent liquid removal process for removing liquid pattern material 312 adhering to the mask surface is performed (step S203). Then, the liquid pattern material 312 in the pattern forming openings is dried and annealed in the heating and solidifying process (step S204, step S205).

Once annealing the pattern is completed, the process returns to the pattern material supply process in step S202, and steps S202 to S205 are repeated the necessary number of times. Once the last pattern material annealing process is completed, the mask removal process is performed as shown in step S206.

It should be noted that as may be required, steps S204 to S206 can be performed after repeating the pattern material supply process of step S202 and the adherent liquid removal process of step S203 the necessary number of times, or the pattern annealing process of step S205 and the mask removal process of step S206 can be performed after repeating steps S202 to S204 the necessary number of times, as indicated by the dotted line in Fig. 17.

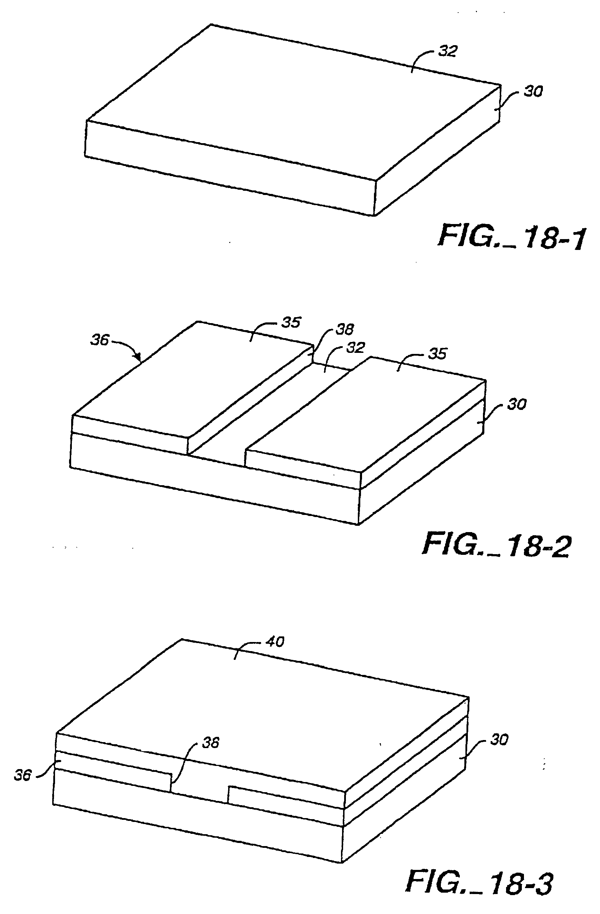

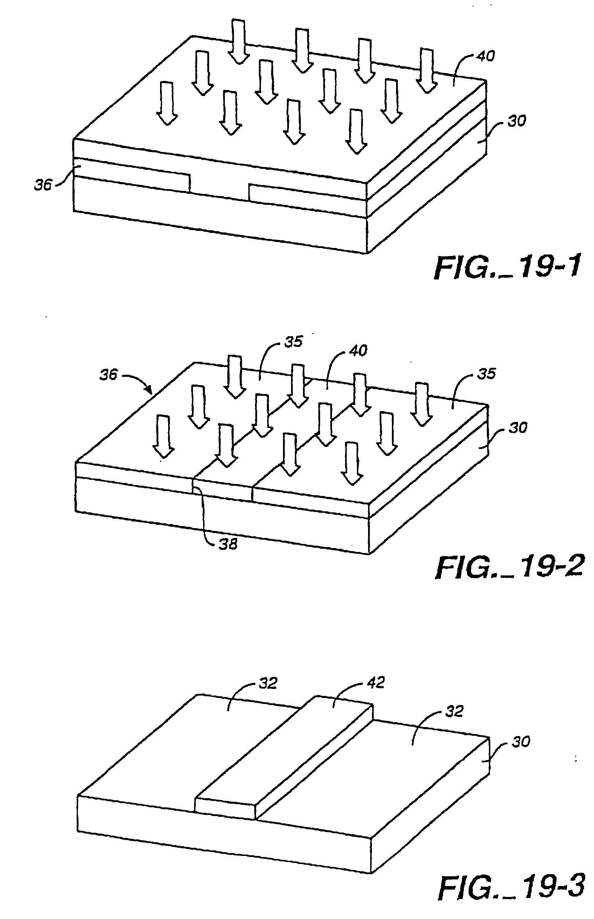

Fig. 18 and Fig. 19 are descriptive diagrams of a manufacturing process applying a pattern forming method according to an embodiment of the invention to a semiconductor substrate.

If a pattern forming method according to an embodiment of the present invention is applied to a process for forming lines on a semiconductor substrate as the workpiece, a semiconductor substrate 30 as shown in Fig. 18 (1) is first introduced to the mask material coating unit 110 of the mask forming unit 100 and placed on table 112. While then rotating the semiconductor substrate 30 with the table 112 by means of motor 118, a photoresist 114 is dripped from the resist supply unit 116 to coat an organic photoresist onto the surface 32 of the semiconductor substrate 30. The photoresist is then dried to form a photoresist film 35 comprising an organic film as the mask material (see Fig. 18 (2)).

After forming the photoresist film 35, the semiconductor substrate 30 is conveyed to the exposure unit 122, light 126 is emitted through the transfer mask 132 from above the photoresist film 35 to expose a wiring pattern on the surface of the photoresist film 35 (exposure process). The semiconductor substrate 30 with the exposed photoresist film 35 is then introduced to the developer unit 124 and immersed in developer solution 138 to develop the photoresist film 35. This forms a mask 36 having channels 38 that will be the pattern forming openings (recesses) exposing the surface 32 of the semiconductor substrate 30 where lines are to be formed as shown in Fig. 18 (2). Note that the width of these channels 38 is the same as the width of the wiring lines.

After thus forming a mask 36 having channels 38 exposing the surface 32 of semiconductor substrate 30, the mask 36 is coated with a liquid inorganic electrically conductive material (liquid pattern material), thus forming an inorganic conductive film 40 filling the channels 38 and covering the top of the mask 36 as shown in Fig. 18 (3). Note that spin coating can be used when the inorganic conductive film 40 is formed covering the mask 36. That is, if the semiconductor substrate 30 is spun and the inorganic conductive material is dripped onto the spinning center of the spinning semiconductor substrate 30, the inorganic conductive material will spread to the outside of the semiconductor substrate 30 by centrifugal force, and a uniform inorganic conductive film 40 can be formed on the surface.

After thus forming the inorganic conductive film 40 on mask 36, an etching solution or mixed gas-liquid etching solution is applied under atmospheric pressure to etch the inorganic conductive film 40 as shown in Fig. 19 (1). Spin etching is preferably used to etch the inorganic conductive film 20, and by using this technique the etching solution can be evenly coated to the surface of the inorganic conductive film 40 and etching the inorganic conductive film 40 can be made to progress evenly.

It will be noted that etching is time controlled and continues until the inorganic conductive film 40 remains only in the channels 38 of the mask 36, that is, until the inorganic conductive film 40 is removed from the surface of the mask 36. It will also be noted that the inorganic conductive film 40 is removed by spin etching in this embodiment, but the invention shall not be so limited as other methods, such as CMP, can be used. In addition, if the inorganic conductive film 40 is removed by CMP, it can be removed in the atmosphere, similarly to spin etching, but with CMP the top of the inorganic conductive film 40 in the channels 38 can be made flat.

After thus etching until the inorganic conductive film 40 remains only in the channels 38, it is sufficient to introduce the semiconductor substrate 30 to an atmospheric pressure plasma device not shown in the figures in order to remove the mask 36 comprising a photoresist film 35 formed on the surface 32 of the semiconductor substrate 30. A line 42 comprising an inorganic conductive film 40 can thus be formed on the surface 32 of semiconductor substrate 30 by thus removing the mask 36 from the surface 32 of semiconductor substrate 30. Furthermore, production without using PFC gas having a high global warming coefficient is possible with this embodiment of the invention because dry etching or cleaning in a chamber is not necessary as it is with conventional manufacturing processes.

It should be noted that while this embodiment is described as forming the inorganic conductive film 40 on the mask 36 soon after forming the mask on the semiconductor substrate 30, it is desirable to introduce the semiconductor substrate 30 to the hydrophobic processing unit 200 shown in Fig. 3 for hydrophobic processing after the mask 36 with channels 38 is formed. This hydrophobic process is accomplished as follows.

The semiconductor substrate 30 with mask 36 disposed thereon is conveyed into the process chamber 218 shown in Fig. 3. Then, $CF_4$ is introduced at atmospheric pressure to the arc discharge chamber 210 from the gas supply source 214, and a gaseous discharge is generated in the arc discharge chamber 210. This caus-

es the $CF_4$ to break down, producing active fluorine. When the process gas 216 containing active fluorine is then supplied to the process chamber 218, the surface of the mask 36, which is an organic film, is fluorinated and becomes hydrophobic. As a result, the liquid inorganic conductive material thus moves easily across the surface of the hydrophobic processed mask when a liquid inorganic conductive material is dripped onto the rotating semiconductor substrate 30, the liquid inorganic conductive material can be easily supplied to the channels 38, it is difficult for the liquid inorganic conductive material to adhere to the surface of the mask 36, and the liquid inorganic conductive material can be selectively supplied to the channels 38. Etching (etch back) the inorganic conductive film 40 on the mask 36 as described in the above embodiment is therefore not necessary, and processing can be further simplified. It should be noted that if the hydrophobic process heats the semiconductor substrate 30 to a suitable temperature, such as approximately 80° to 150°C, the mask 36 fluorination reaction can be promoted and process time can be shortened.

Furthermore, if a specific volume discharge device such as the print head of an inkjet printer is used to supply the liquid inorganic conductive material and fill the channels 38 of the mask 36, the liquid inorganic conductive material can be supplied to the channels 38 without the liquid inorganic conductive material adhering to the mask 36 surface. Yet further, the liquid inorganic conductive material, that is, the pattern material, can be supplied to the channels 38 of the mask 36 by means of the pattern material supply process 300 shown in Fig. 4 when forming fine lines 42 with a width of 1 μm or less.

That is, after hydrophobic processing the mask 36 in hydrophobic processing unit 200, the semiconductor substrate 30 is placed on the process stage 318 of the pattern material supply unit 300. While then rotating the process stage 318 by means of motor 320, a positive dc voltage is applied to the semiconductor substrate 30 by the dc power supply 328 through the intervening process stage 318. In addition, while supplying the liquid inorganic conductive material from the liquid pattern material source 314 to the atomizer 311, nitrogen for misting is supplied from the mist gas source 316 to the atomizer 311 to produce a particle mist of approximately 0.2 μm or less from the liquid inorganic conductive material and discharge the particle mist from the shower head 310. The semiconductor substrate 30 is heated by a heater 326 built in to the process stage 318 at this time to a temperature suitable for evaporating solvent in the liquid inorganic conductive material.

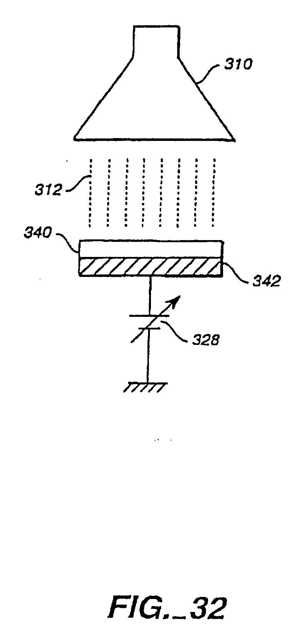

It should be noted that because the semiconductor substrate is conductive, it is simple to create a uniform field in the process surface. However, if glass or other dielectric material is processed, it is desirable to place a dielectric process material (dielectric process substrate) 340 on the flat electrode 342 as shown in Fig. 32 to form a uniform field on the dielectric process substrate 340 by way of intervening flat electrode 342.

It will be further noted that while a dc power supply 28 is used as the power source for applying a voltage to the workpiece 20 or dielectric process substrate 340 in this embodiment, the invention shall not be so limited as an ac power source could be used.

The mist particles of the liquid inorganic conductive material discharged from the shower head 310 are negatively charged. Static attraction thus works between the semiconductor substrate 30 to which a positive dc voltage is applied and the inorganic conductive material particles, causing the particles of the liquid inorganic conductive material to adhere to the rotating semiconductor substrate 30. The particles slide over the mask 36 surface and enter the channels 38 because the surface of the mask 36 formed on the semiconductor substrate 30 has been processed for liquid-repellence. After supplying the inorganic conductive material to the channels 38 for a specific time, unnecessary liquid inorganic conductive material adhering to the mask 36 surface is removed with the air knife 330. If this process removing unnecessary adherent liquid is performed while the semiconductor substrate 30 is turning or the semiconductor substrate 30 is inclined, it can be accomplished more efficiently using a lower air pressure. If the liquid inorganic conductive material is supplied to the channels 38 while heating the semiconductor substrate 30, the liquid inorganic conductive material drying process can be omitted and a fine inorganic conductive film 40 can be achieved.

It should be noted that the above adherent liquid removal process can be performed after the pattern material supply process supplying the liquid inorganic conductive material to the channels 38 of the mask 36 is completed. Furthermore, the inorganic conductive film 40 forming the lines 42 can as necessary be annealed in the pattern material setting unit 500 indicated by the dotted line in Fig. 1.

The inventors developed examples of applications for a pattern forming method according to the present invention in a method for separating elements in a semiconductor device, a process for forming FET gate electrodes, and a process for forming contacts between wiring layers. The procedures for these three examples are described next below as embodiments of the invention. It should be noted that further description of aspects common to the pattern forming methods described above is omitted below.

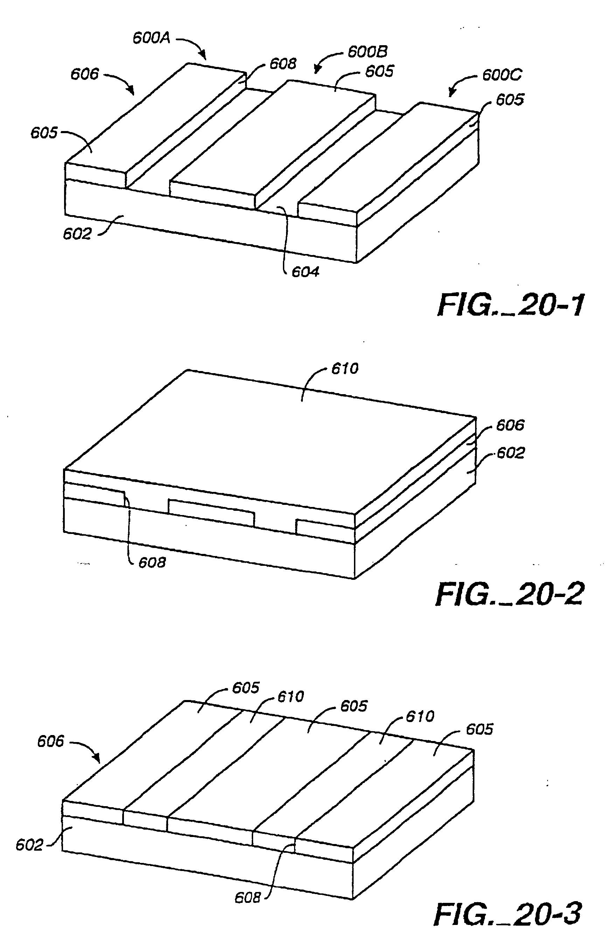

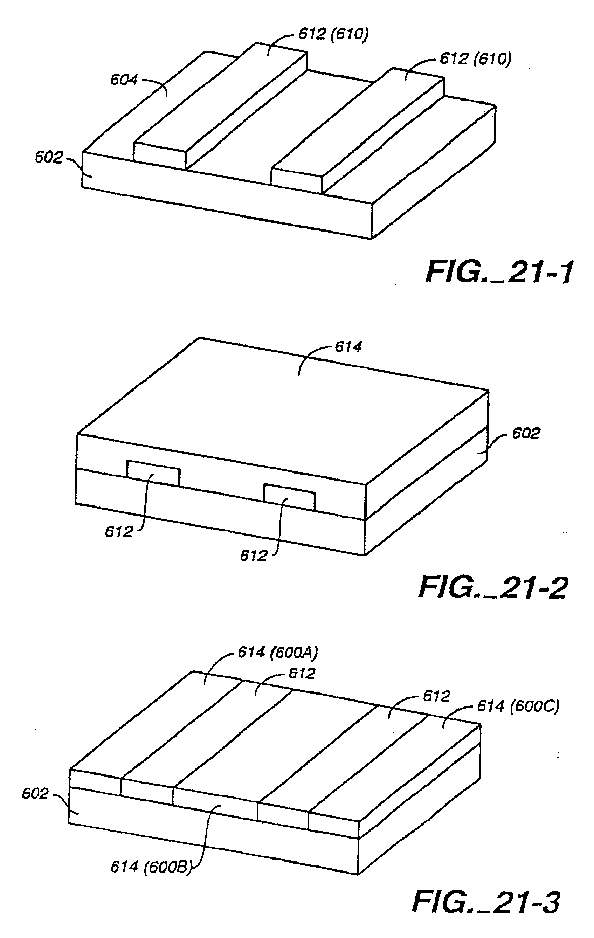

Fig. 20 and Fig. 21 are manufacturing process diagrams used to describe applying a pattern forming method according to an embodiment of the present invention to a method for separating elements in the production of a semiconductor device, and correspond to a shallow trench forming process in a conventional semiconductor device manufacturing process.

In a semiconductor substrate it is necessary to form a dielectric pattern between the element areas 600A 600B, 600C where semiconductor elements are formed to isolate the elements and prevent shorting between the elements formed in the element areas 600A, 600B, 600C.

To this end a mask 606 comprising a photoresist film, that is, mask material, is formed on the surface 604 of the semiconductor substrate 602. That is, the surface 604 of semiconductor substrate 602 is first coated with a photoresist to form a photoresist film 605. The photoresist film 605 is then exposed and developed through the mask for forming the element isolation areas, thus forming a mask 606 having channels 608 exposing the substrate surface 604 between the element areas 600A, 600B, 600C.

The semiconductor substrate 602 on which channels 608 are formed is then introduced to a spin coating process whereby the surface is coated with a liquid dielectric material so as to fill the channels 608 and cover the mask 606, forming dielectric layer 610. This state is shown in (2) of the same figure. After thus forming the dielectric layer 610, the dielectric layer 610 is etched with a spin etching method, thus exposing the photoresist film 605 forming the mask 606 as shown in (3) of the same figure.

The mask 606 is then removed in an atmospheric pressure plasma device as shown in Fig. 21 (1). A dielectric pattern 612 comprising dielectric layer 610 for element isolation is thus formed on the surface 604 of semiconductor substrate 602.

After thus removing the mask 606, the semiconductor substrate 602 is introduced to a spin coating process to coat the dielectric pattern 612 and form a silicon layer 614. After thus forming the silicon layer 614, the semiconductor substrate 602 is again introduced to a spin etching process to etch the silicon layer 614 until the surface of the dielectric pattern 612 is exposed. Element areas 600 (600A, 600B, 600C) are thus formed from the silicon layers 614 separated by the dielectric pattern 612.

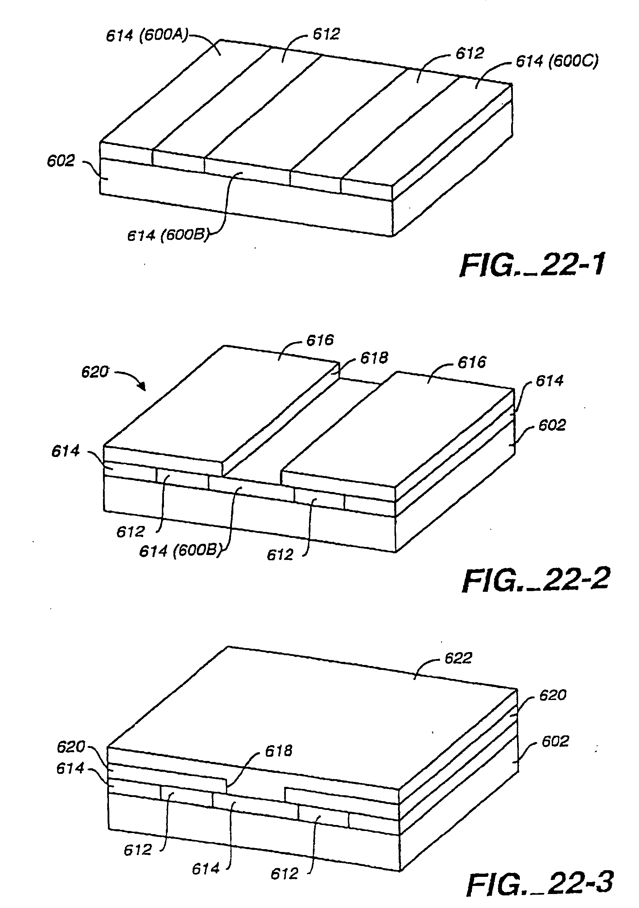

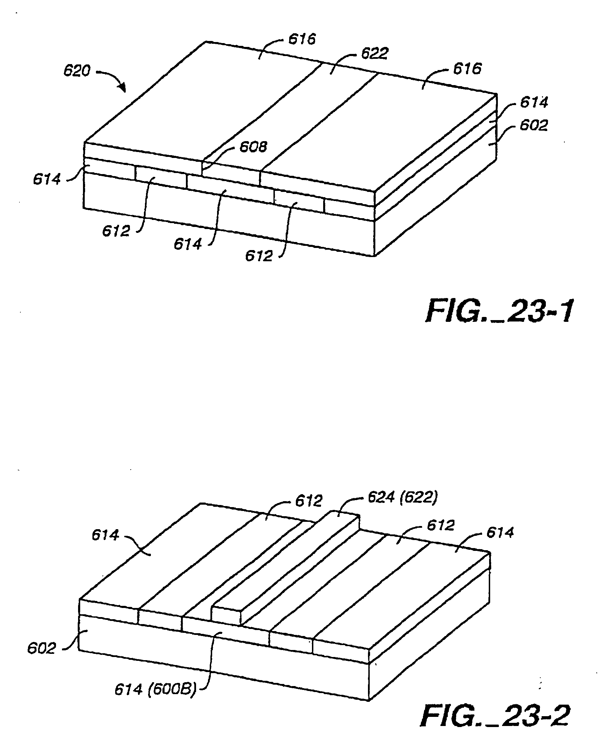

Fig. 22 and Fig. 23 are manufacturing process diagrams used to describe applying a pattern forming method according to an embodiment of the invention to a process for forming FET gate electrodes.

When forming MOS-FET gate electrodes, a semiconductor substrate 602 having element areas 600 separated by dielectric pattern 612 as shown in Fig. 22 (1) is introduced to an oxidation oven. The silicon layer 614 of the element areas 600 is then thermally oxidized to form a thin gate electrode film (not shown in the figure) of silicon dioxide on the surface of the silicon layer 614.

The silicon layer 614 and dielectric pattern 612 are then covered with a photoresist coating, forming the photoresist film 616 as shown in (2) of the same figure. The photoresist film 616 is then exposed and developed through the gate electrode formation mask, forming a mask 620 having channel 618 exposing the surface of silicon layer 614 forming element area 600B. Note that the width of this channel 618 is the same as the width of the gate electrode.

The semiconductor substrate 602 on which channel 618 is formed is then introduced to a spin coating process to fill the channel 618, apply a liquid inorganic conductive material so as to cover the mask 620 and form an inorganic conductive film 622. This state is shown in (3) of the same figure.

After thus forming the inorganic conductive film 622, a spin etching process continues etching until the surface of the mask 620 is exposed as shown in Fig. 23 (1). The photoresist film 616 forming the mask 620 is then removed by an atmospheric pressure plasma device as shown in (2) of the same figure. It is thus possible to form a gate electrode 624 comprising an inorganic conductive film 622 on the silicon layer 614 forming element area 600A with a gate oxidation film therebetween.

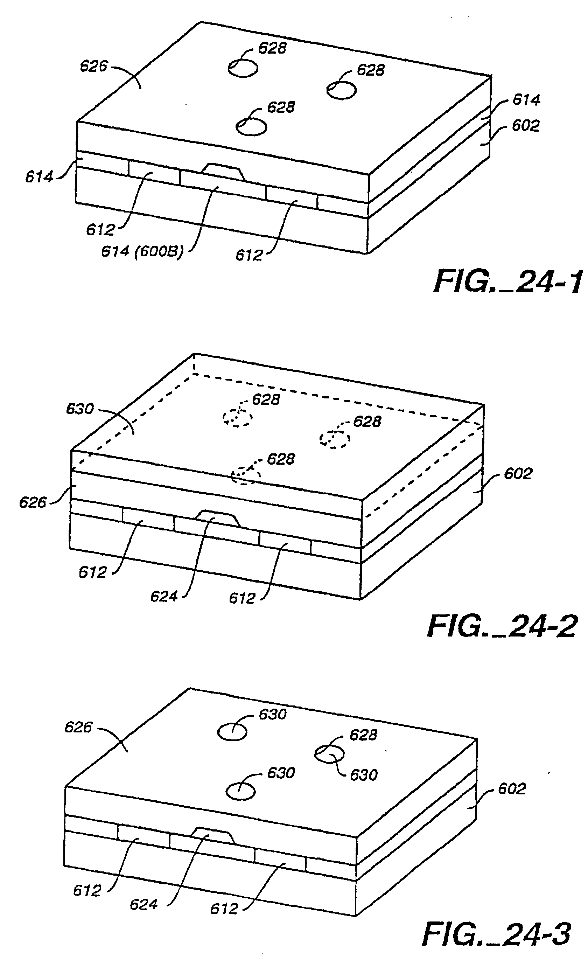

Fig. 24, Fig. 25, and Fig. 26 are manufacturing process diagrams used to describe applying a pattern forming method according to an embodiment of the present invention to a process forming contacts between wiring layers.

As above, the semiconductor substrate 620 having gate electrode 624 disposed thereon is conveyed into an ion injection device not shown in the figures. Then, using the gate electrode 524 as a mask, impurity ions are injected to the exposed part on both sides of the gate electrode 624 in element area 600B to produce a source area and drain area (neither shown in the figure).

Then, as shown in Fig. 24 (1), a photoresist is applied to cover the dielectric pattern 612, silicon layer 614, and gate electrode 624, forming photoresist film 626. Exposure and development through the mask for contact hole formation then forms contact holes 628 in the photoresist film 626, producing a mask exposing the surface of element area 600B forming a source area and drain area, and the surface of the gate electrode 624.

Then, as shown in (2) of the same figure, a solution containing tungsten is applied covering the photoresist film (mask) 626 to build up tungsten 630, filling tungsten 630 to the contact holes 628. The tungsten deposited on the surface of photoresist film 626 is then removed by spin etching or CMP to expose the surface of the photoresist film 626 as shown in (3) of the same figure.

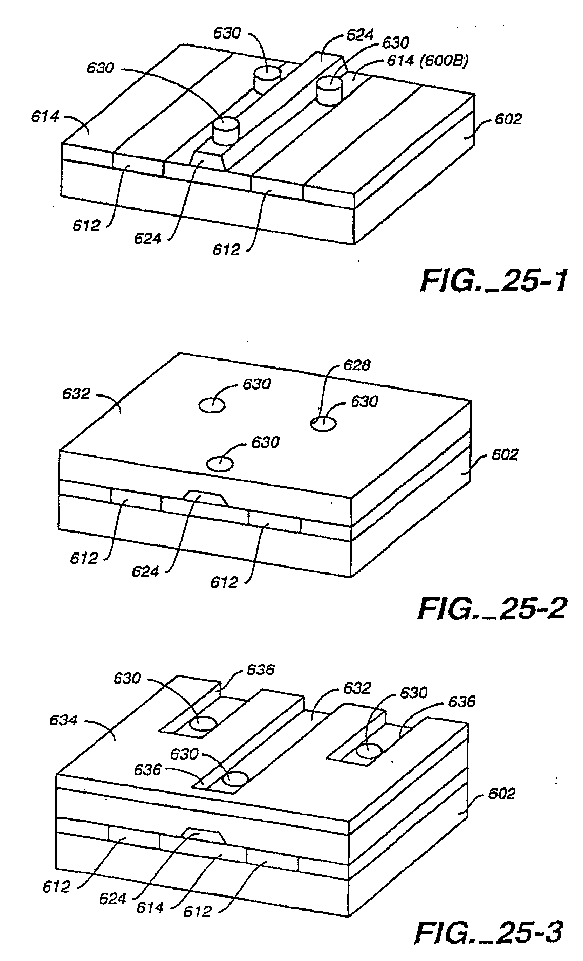

The photoresist film 626 is then removed by atmospheric pressure plasma or spin etching using a different etching solution. This results in the tungsten (plug) 630 filling the contact holes 628 projecting up from the surface of the element area 600B and gate electrode 624 as shown in Fig. 25 (1).

A dielectric layer 632 is then formed covering the tungsten plugs 630 by applying a liquid dielectric material by spin coating, for example. Then, as shown in (2) of the same figure, the dielectric layer 632 is etched by a spin etching process until the surface of the tungsten plug 630 is exposed.

A photoresist film 634 is then formed by applying a photoresist over the dielectric layer 632 by spin coating, for example (see Fig. 25 (3)). The photoresist film 634 is then exposed and developed through a wiring formation mask, forming a mask having wiring trenches 636 exposing the top of the dielectric layer 632 as shown in (3) of the same figure.

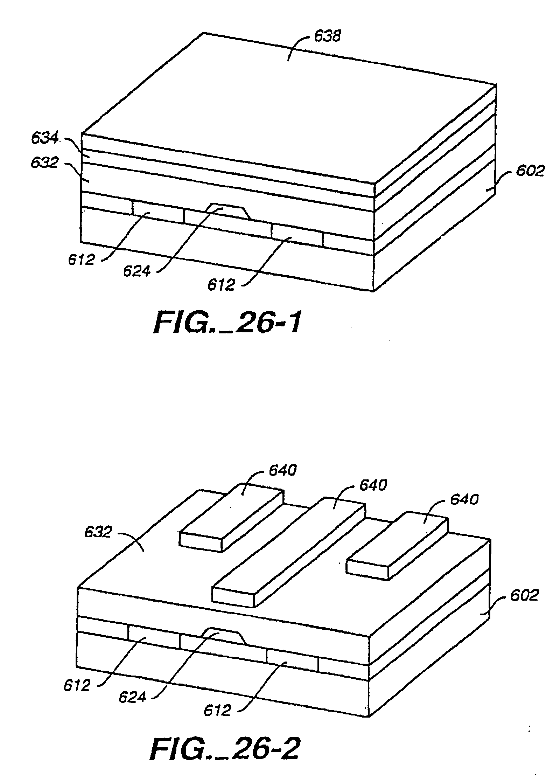

After thus forming trenches 636 in the photoresist film 634, an aluminum layer 638 is formed to fill the trenches 636 as shown in Fig. 26 (1). The aluminum layer 638 is then etched by spin etching, for example, exposing the surface of the photoresist film (mask) 634 having the wiring trenches 636. The photoresist film 634 is then removed by an atmospheric pressure plasma process. Aluminum wiring 640 electrically connected to the tungsten plugs 630 can thus be formed on top of dielectric layer 632 as shown in (2) of the same figure.

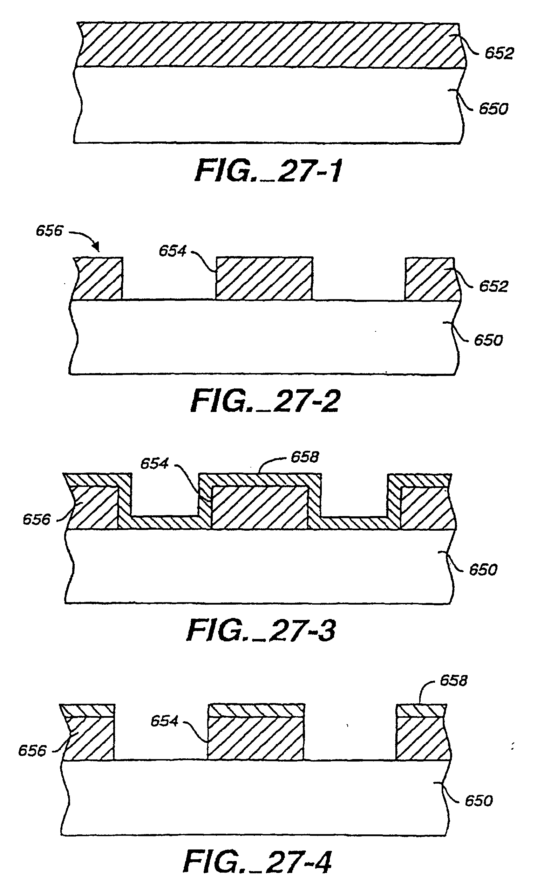

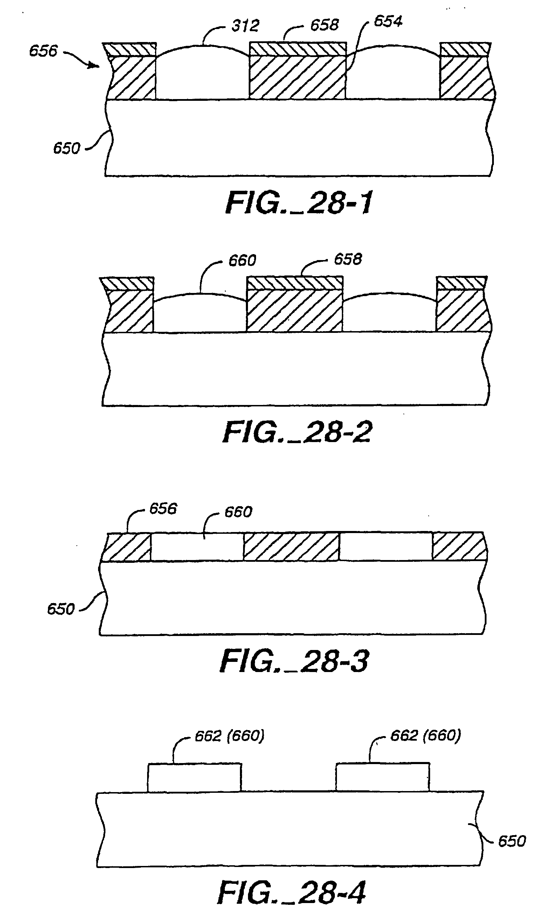

Fig. 27 and Fig. 28 show the steps for forming transparent electrodes of ITO (indium tin oxide) for a liquid crystal display device using a patterning method of the present invention. To form an ITO transparent electrode, a resist film 652 is first formed over the entire surface of the cleaned glass substrate 650 that is the workpiece 20 as shown in Fig. 27 (1). More specifically, the glass substrate 650 is conveyed into the mask material coating unit 110 of the mask forming unit 100 shown in Fig. 2. With the glass substrate 650 placed on a rotating table 112, a photoresist 114 is then dripped from above and dried to form a resist film 652. The thickness of the resist film 652 is made greater than the height of the electrode pattern to be formed.

The glass substrate 650 with resist film 652 formed thereon is then conveyed to the mask patterning unit 120 as shown in Fig. 2. After then exposing the resist film 652 in the exposure unit 122, the glass substrate 650 is immersed in developer solution 138 in the developer unit 124 to form resist film 652. A mask 656 comprising a resist film 652 having openings (trenches) for electrode pattern forming 654 exposing the surface of the glass substrate 650 is thus formed as shown in Fig. 27 (2).

A hydrophobic process is then applied to the surface of the mask 656. More specifically, a fluoropolymer film 658 is formed on the surface of the glass substrate 650 and mask 656 as shown in Fig. 27 (3). The fluoropolymer film 658 is formed as follows. It should be noted that the hydrophobic process of this embodiment forming the fluoropolymer film 658 is described using an apparatus of the mask forming unit 150 shown in Fig. 6 as the hydrophobic processing unit 200 shown in Fig. 1.

The glass substrate 650 is first introduced to the film processing chamber 152 shown in Fig. 6 and placed on the film formation stage 154. The transfer mask 24 shown in Fig. 6 is not used, however.

Next, air inside the film processing chamber 152 is removed by vacuum pump 160. The liquid fluorocompound 170 such as $C_8F_{18}$ in the container 172 of the film formation material supply unit 168 is then heated by heater 174 to vaporize the liquid fluorocompound 170. Nitrogen or other carrier gas is then flowed from the carrier gas supply unit 178 into the supply line 166 to carry the liquid fluorocompound 170 vapor into the film processing chamber 152. A high frequency voltage is then applied between the film formation stage 154 and high frequency electrode 158 by means of high frequency power source 156, and an arc is discharged through the liquid fluorocompound 170 vapor introduced to the film processing chamber 152. Some of the bonds of the straight chain liquid fluorocompound 170 are thus broken, and the resulting activated fluorocompound vapor reaching the surface of the glass substrate 650 polymerizes, forming a hydrophobic fluoropolymer film 658 over the entire surface of the glass substrate 650. Note that this polymer film 658 is formed to a thickness of approximately 100 angstroms.

It should be noted that the fluoropolymer film 658 is also formed on the surface of the glass substrate 650 exposed by the electrode pattern forming openings (referred to simply below as openings) 654 in the above-described hydrophobic process. The inside of the openings 654 is therefore processed for hydrophilic. More specifically, ultraviolet light is emitted into the electrode pattern forming openings 654 to remove the fluoropolymer film 658 as shown in Fig. 27 (4).

The fluoropolymer film 658 is removed by placing an ultraviolet light emission mask, which passes light only in the parts corresponding to the electrode pattern forming areas, over the glass substrate 650 and then emitting the ultraviolet light. The ultraviolet light thus breaks the bonds of the fluoropolymer film 658, and the fluoropolymer film 658 formed in the openings 654 is removed. The resist and other organic materials adhering to the glass substrate 650 are also broken down and removed. hydrophilic is thus imparted to the electrode pattern forming part of the glass substrate 650.

It should be noted that if the solvent of the liquid pattern material is octane or other organic solvent, an adhesion improvement process using a nonionic surfactant is applied in addition to the above. More specifically, a 1% aqueous solution of a nonionic surfactant (RO-$(CH_2CH_2O)nH$) is applied to the surface of the glass substrate 650 to improve adhesion with the liquid pattern material. It should be noted that the nonionic surfactant can be applied in the film formation chamber directly before the film formation process described next, or in a different process chamber. The adhesion improvement process applied to the glass substrate 650 can also be performed with the film formation process in the film formation processing chamber.

Liquid pattern material 312 is then supplied to fill the inside of the electrode pattern forming openings 654 as shown in Fig. 28 (1). More specifically, the glass substrate 650 is introduced to the pattern material supply unit 300 shown in Fig. 4 and placed on the process stage 232. The atomizer 311 then produces mist particles from the liquid pattern material 312, which is discharged from the shower head 310 and supplied to the glass substrate 650.

In this embodiment the liquid pattern material 312 is a dispersion of ITO microparticles (with a particle diameter of 0.1 $\mu$m or less) in octane ($C_8H_{18}$) or other organic solvent.

It should be noted that a film improvement process can also be accomplished by supplying a reaction gas simultaneously to supplying the liquid pattern material 312. More specifically, the reaction gas is mixed with the liquid pattern material 312 and supplied to the atomizer 311 to produce liquid pattern material 12 particles that are then discharged from the shower head 310. The reaction gas can be carbon tetrafluoride gas or oxygen, and can adjust the percentage of oxides in the formed ITO film.

It should be noted that if an electron beam is emitted from an electron beam emission tube not shown in the figures to the discharged liquid pattern material 312, the emitted electron beam will negatively charge the atomized liquid pattern material, and the charge capacity of the drops can be increased.

Atomized by the atomizer 311 and discharged as a mist by the shower head 310, the liquid pattern material 312 can free fall and coat the surface of the glass substrate 650 on the process table 318, but a 10 kV bias voltage, for example, can be applied to the process stage 318 to positively charge the surface of the glass substrate 650 to attract the drops of the negatively charged liquid pattern material 312. It should be further noted that because producing a mist negatively charges the liquid pattern material 312 naturally, those drops that do not collide with the electron beam can also be attracted to the glass substrate 650.

If the glass substrate 650 is rotated by a motor 32, the liquid pattern material 312 on the fluoropolymer film 658 will enter the electrode pattern forming openings 654. The liquid pattern material 312 can therefore be supplied quickly to the openings 654, and the liquid pattern material 312 will uniformly fill the openings 654.

When supplying the liquid pattern material 312 to the openings 654 is completed, excess liquid pattern material 312 adhering to the mask 656 is removed with an air knife 330. It should be noted that the excess liquid pattern material can also be removed by spinning the glass substrate 650. The liquid pattern material 312 on the mask 656 can also be removed by tilting the glass substrate 650.

The glass substrate 650 is then heated to dry the liquid pattern material 312. In this embodiment supplying the liquid pattern material 312 to the electrode pattern forming openings 654 of the mask 656 and drying the pattern material occur simultaneously. That is, the glass substrate 650 is heated to a temperature vaporizing solvent in the liquid pattern material 312 by means of the heater 326 built in to the process table 318 on which the glass substrate 650 is placed. Because supplying the liquid pattern material 312 to the electrode pattern forming openings 654 and drying the liquid pattern material 312 thus occur at the same time, the process can be simplified and the pattern forming time can be shortened. Moreover, because the liquid pattern material 312 is misted with nitrogen and drying the liquid pattern material 312 occurs in an inert gas atmosphere, the pattern material can be prevented from oxidizing more than necessary.

Furthermore, the drying temperature of the liquid pattern material 312 is below the boiling point of the organic solvent in order to avoid producing voids in the pattern film. For example, if the solvent in the liquid pattern material 312 is octane ($C_8H_{18}$), the solvent boiling point is approximately 170°C, and the liquid pattern material 312 is therefore heated to 150°C or less in a nitrogen atmosphere. The liquid pattern material 312 thus solidifies as pattern film 660 and an ITO layer is formed (Fig. 28 (2)).

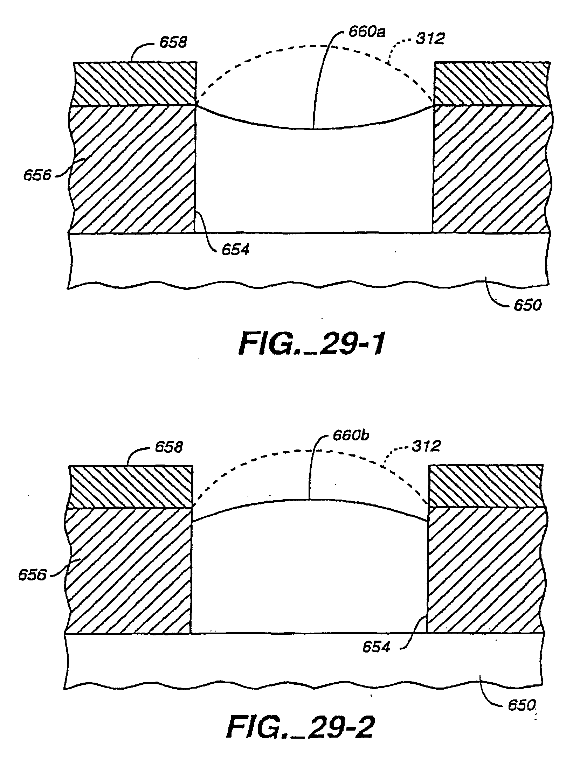

It should be noted that when the drying process follows the pattern material supply process, drying is preferably at 150°C or less for 5 minutes or more. The surface of the pattern film 660 can also be formed to a desired configuration by controlling the rate at which the temperature rises in the drying process. Fig. 29 shows the correlation between the speed at which the drying temperature rises and the surface configuration of the pattern film.

After the preceding film formation process ends, the electrode pattern forming openings 654 in the mask 656 are filled with liquid pattern material 312 as shown in Fig. 29 (1). If the temperature rises rapidly in the drying process, solvent contained in the liquid pattern material 312 evaporates primarily from the middle. This results in the dried pattern film 660a having a depression in the middle. On the other hand, if the temperature rises slowly in the drying process, solvent contained in the liquid pattern material 312 evaporates uniformly throughout. This results in a swelled center in the dried pattern film 660b as shown in Fig. 29 (2).

The surface of the pattern film 660 can therefore be formed to the desired shape by increasing the drying temperature while observing the surface configuration of the pattern film 660. It will be noted that the surface of the pattern film can be made flat, a shape between the shapes shown in Fig. 29 (1) and (2).

The pattern film is then annealed and the mask 656 removed. The annealing temperature of the pattern film 660 and the carbonization temperature of the resist are first compared. If the carbonization temperature of the resist film forming the mask 656 is higher than the annealing temperature of the pattern film 660, the pattern annealing process follows the drying process.

However, if the carbonization temperature of the resist film is lower than the annealing temperature of the pattern film 660, the resist film (mask 656) will carbonize during the annealing process and removing the mask 656 will be difficult. In this case, therefore, the mask removal process is performed first and then the pattern annealing process is performed. It should be noted that because the carbonization temperature of PMMA, a typical resist, is approximately 260°C, and the annealing temperature of an ITO film is 500°C or higher, the resist removal process is performed first and then the annealing process is performed.

It should be noted that if it is necessary to shape the surface of the pattern film 660, a shaping process as shown in Fig. 28 (3) can be applied before the mask removal process. More specifically, CMP (chemical mechanical polishing) or other process is run until the pattern film 660 reaches the desired thickness. There is little deformation or damage to the pattern film 660 at this time because the edge of the pattern film 660 is protected by the mask 656. Residual liquid pattern material 312 on the surface of the fluoropolymer film 658 and the fluoropolymer film 658 itself are also removed at the same time in conjunction with the shaping process.

The mask 656 is removed next. The mask removal process is accomplished by heating the glass substrate 650 in an oxygen or activated oxygen atmosphere.

The glass substrate 650 is next heated to anneal the pattern film 660. The pattern annealing process can be done in air or in an inert gas environment to prevent heat oxidation of the pattern film 660. Annealing is done at 500°C or higher in an nitrogen atmosphere for an ITO film. It should be noted that film improvement and annealing can be done at the same time by annealing in an active gas environment containing fluorine radicals or ozone radicals, for example, if the annealing process is done at a low temperature of 400°C or less.

An electrode pattern 662 is thus formed from an ITO pattern film 660 on the surface of the glass substrate 650 as shown in Fig. 28 (4).

All processes described in the above pattern forming method can be performed in an environment at or near atmospheric pressure because of the change from a conventional process for removing the pattern material formed on the process member surface to a process for adding to or filling trenches. It is therefore not necessary to provide vacuum equipment, and less energy is required to run the equipment. The manufacturing cost can therefore be reduced.

Furthermore, by using liquid materials and forming films by dispersing a liquid pattern material mist to the surface of the coated substrate, it is possible to form a film only on the processed substrate and an operation for removing by means of PFC gas a film formed on the side walls of the film formation process chamber is not required as it is with the prior art. Yet further, because the particle size can be reduced to approximately 0.2 μm by generating a mist, this process provides excellent step coverage and trench filling performance, and can form a fine pattern film 660 with a line width of 1 μm or less, for example. Moreover, because the misted particles are charged naturally, the film formation speed can be improved as described below. A pattern film 660 that is uniform across the glass substrate 650 can also be formed by discharging a liquid pattern material 312 mist.

The liquid pattern material 312 can also be quickly supplied to the electrode pattern forming openings 654 and the production cost can be reduced by applying a bias voltage to the glass substrate 650 to attract the misted liquid pattern material 312.

The time required to fill the liquid pattern material 312 into the openings 654 can be shortened and the time required to remove excess liquid pattern material from the mask 656 can also be shortened by processing the mask 656 so that it is hydrophobic to the liquid pattern material 312. The manufacturing cost can therefore be reduced.

Furthermore, because the bottom of the electrode pattern forming openings 654 is processed to be hydrophilic to the liquid pattern material 312, patterning precision is improved and a pattern film 660 can be formed with the desired shape.

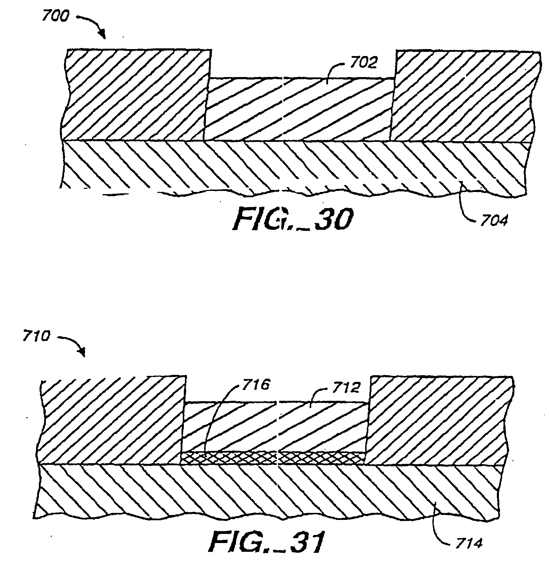

It will be noted that a structure having a functional thin film formed on a substrate by a pattern forming method according to the present invention is applicable to, for example, semiconductor devices, electrical circuits, display modules, and light emitting devices. Examples thereof are shown in Fig. 30 and Fig. 31. Fig. 30 is a schematic diagram of a semiconductor device, electrical circuit, or display module, for example, and Fig. 31 is a schematic diagram of a microstructure forming a light-emitting element, for example.

In the case of primarily a semiconductor device or electrical circuit, the functional thin film forming the microstructure in Fig. 30 is a metallic thin film of a wiring pattern disposed on a substrate, for example, and in the case of a display module the functional thin film 702 of the microstructure 700 is, for example, an organic molecular film of a color filter disposed on a transparent substrate 704. A color filter is shown by way of example in Fig. 30, but the pattern forming method of the present invention can be used to form other types of functional thin films.

In Fig. 31 the functional thin film 712 of the microstructure 710 forming a light-emitting element is an organic EL (electroluminescence) thin film used in a light-emitting layer, for example, and an electrode (not shown in the figure) paired with a transparent electrode 716 shown in the figure formed on a transparent substrate 714 is formed to form an element disposing functional thin film 712 therebetween. It will also be obvious that the electrodes can be formed using the pattern forming method of the present invention.

The film thickness of the functional thin film 712 can be determined according to the intended application of the microstructure, but is preferably 0.02 to 4 μm. Products manufactured by applying the film formation method of the present invention are high quality, and superior to the conventional method with respect to production cost and simplification of the production process.

APPLICATIONS IN INDUSTRY

As described above, the present invention can form a pattern by simply filling a liquid pattern material to pattern forming trenches and solidifying the liquid pattern material. The present invention therefore does not need to use high cost vacuum equipment. As a result, the present invention does not require a load lock chamber for transporting work into a vacuum, plural dry pumps and turbo pumps for making the process chamber a vacuum, the increased footprint required to provide plural chambers in order to improve throughput, the attendant increase in clean room size, and the increase in basic equipment used to maintain the same, and therefore helps simplify the equipment, reduce the amount of energy used in pattern forming, and reduce the pattern forming cost. Furthermore, because the present invention does not use CVD, for example, it is not necessary to use PFC gas having a high global warming coefficient in order to clean the equipment, thus reducing cost and significantly reducing the effect on the global environment.

**Claims**

1.  A pattern forming method **characterized by** forming a mask having pattern forming openings on a workpiece surface, and then supplying and solidifying a liquid pattern material in the pattern forming openings of the mask.

2.  A pattern forming method comprising:

    a mask forming process for forming a mask having pattern forming openings on a workpiece surface;
    a pattern material supplying process for supplying the liquid pattern material to the mask openings while also drying the liquid pattern material;
    a process for removing the mask from the workpiece; and
    an annealing process for annealing dried solute of the liquid pattern material.

3.  A pattern forming method comprising:

    a mask forming process for forming a mask having pattern forming openings on a workpiece surface;
    a pattern material supplying process for supplying a liquid pattern material to the mask openings;
    a drying process for evaporating solvent in the liquid pattern material;

    a mask removal process for removing the mask from the workpiece; and
    an annealing process for annealing dried solute in the liquid pattern material.

4.  A pattern forming method comprising:

    a mask forming process for forming a mask having pattern forming openings on a workpiece surface;
    a pattern material supplying process for supplying a liquid pattern material to the mask openings;
    a solidifying process for solidifying the liquid pattern material supplied into the openings; and
    a mask removal process for removing the mask from the workpiece after sequentially performing plural times the pattern material supply process and solidifying process.

5.  A pattern forming method comprising:

    a mask forming process for forming a mask having pattern forming openings on a workpiece surface;
    a pattern material supplying process for supplying a liquid pattern material to the mask openings;
    an adherent liquid removal process for removing liquid pattern material that adhered to the mask surface when the liquid pattern material was supplied to the openings;
    a drying process for drying by evaporating solvent in the liquid pattern material in the openings;
    an annealing process for annealing the dried solute after sequentially performing plural times the pattern material supply process, adherent liquid removal process, and drying process; and
    a mask removal process for removing the mask from the workpiece.

6.  A pattern forming method comprising:

    a mask forming process for forming a mask having pattern forming openings on a workpiece surface;
    a pattern material supplying process for supplying a liquid pattern material to the mask openings;
    a drying process for drying by evaporating solvent in the liquid pattern material in the openings; and
    an annealing process for annealing the dried solute after sequentially performing plural times the pattern material supply process and drying process.

7. A pattern forming method comprising:

   a mask forming process for forming a mask having pattern forming openings on a workpiece surface;
   a pattern material supplying process for supplying a liquid pattern material to the mask openings;
   a solidifying process for solidifying the liquid pattern material supplied into the trenches;
   a solid material removal process for removing solids of the liquid pattern material that adhered to the mask surface when the liquid pattern material was supplied to the mask openings; and
   a mask removal process for removing the mask from the workpiece after sequentially performing plural times the pattern material supply process, solidifying process, and solid material removal process.

8. A pattern forming method comprising:

   a mask forming process for forming a mask having pattern forming openings on a workpiece surface;
   a pattern material supplying process for supplying a liquid pattern material to the mask openings;
   a drying process for drying by evaporating solvent in the liquid pattern material in the openings;
   a solid material removal process for removing dried solids of the liquid pattern material that adhered to the mask surface when the liquid pattern material was supplied to the mask openings;
   an annealing process for annealing the dried solute after sequentially performing plural times the pattern material supply process, drying process, solid material removal process; and
   a mask removal process for removing the mask from the workpiece.

9. A pattern forming method comprising:

   a mask forming process for forming a mask having pattern forming openings on a workpiece surface;
   a pattern material supplying process for supplying a liquid pattern material to the mask openings;
   a drying process for drying by evaporating solvent in the liquid pattern material in the openings;
   a solid material removal process for removing dried solids of the liquid pattern material that adhered to the mask surface when the liquid pattern material was supplied to the mask openings;
   an annealing process for annealing the dried solute; and
   a mask removal process for removing the mask from the workpiece after sequentially performing plural times the pattern material supply process, drying process, solid material removal process, and annealing process.

10. A pattern forming method as described in any of claims 1 to 9, wherein the mask has hydrophobic on at least the surface thereof.

11. A pattern forming method as described in any of claims 1 to 9, wherein the mask is hydrophobic.

12. A pattern forming method as described in claim 1, claim 4, or claim 7, wherein the liquid pattern material is solidified by applying heat.

13. A pattern forming method as described in claim 12, wherein heating and solidifying the liquid pattern material comprises a drying process for evaporating solvent in the liquid pattern material, and an annealing process for annealing the dried solute.

14. A pattern forming method as described in claim 1, wherein the mask is removed from the workpiece after solidifying the liquid pattern material.

15. A pattern forming method as described in any of claims 1 to 4 or claim 7, wherein: the liquid pattern material is solidified after removing liquid pattern material that adhered to the mask surface when the liquid pattern material was supplied to the openings.

16. A pattern forming method as described in claim 6, wherein the annealing process is performed after removing the mask from the workpiece.

17. A pattern forming method as described in claim 6, wherein the mask is removed from the workpiece after the annealing process.

18. A pattern forming method as described in claim 2, claim 3, claim 5, claim 6, or claim 8, wherein the process for removing the mask and the annealing process are performed simultaneously.

19. A pattern forming method comprising:

   a mask forming process for forming a mask having pattern forming openings on a workpiece surface;
   a pattern material supplying process for supplying the liquid pattern material to the mask openings while also drying the liquid pattern material;
an annealing process for annealing dried solute of the liquid pattern material; and
a process for removing the mask from the workpiece.

20. A pattern forming method comprising:

a mask forming process for forming a mask having pattern forming openings on a workpiece surface;
a pattern material supplying process for supplying a liquid pattern material to the mask openings;
a drying process for evaporating solvent in the liquid pattern material;
an annealing process for annealing dried solute in the liquid pattern material; and
a mask removal process for removing the mask from the workpiece.

21. A pattern forming method comprising:

a mask forming process for forming a mask having pattern forming openings on a workpiece surface;
a pattern material supplying process for supplying a liquid pattern material to the mask openings;
an adherent liquid removal process for removing liquid pattern material that adhered to the mask surface when the liquid pattern material was supplied to the openings;
a drying process for drying by evaporating solvent in the liquid pattern material in the openings;
a mask removal process for removing the mask from the workpiece after sequentially performing plural times the pattern material supply process, adherent liquid removal process, and drying process; and
an annealing process for annealing the dried solute.

22. A pattern forming method comprising:

a mask forming process for forming a mask having pattern forming openings on a workpiece surface;
a pattern material supplying process for supplying a liquid pattern material to the mask openings;
a drying process for drying by evaporating solvent in the liquid pattern material in the openings;
a solid material removal process for removing dried solids of the liquid pattern material that adhered to the mask surface when the liquid pattern material was supplied to the mask openings;
a mask removal process for removing the mask from the workpiece after sequentially performing plural times the pattern material supply process, drying process, and solid material removal process; and
an annealing process for annealing the dried solute.

23. A pattern forming method **characterized by** supplying and solidifying a liquid pattern material in a specific pattern forming trench disposed in a workpiece.

24. A pattern forming method **characterized by** performing plural times a process for supplying and solidifying a liquid pattern material in a specific pattern forming trench disposed in a workpiece.

25. A pattern forming method comprising:

a pattern material supply process for supplying a liquid pattern material to a specific pattern forming trench disposed in a workpiece;
an adherent liquid removal process for removing liquid pattern material that adhered to the mask surface when the liquid pattern material was supplied to the trench;
a drying process for drying by evaporating solvent in the liquid pattern material in the trench; and
an annealing process for annealing solute contained in the dried liquid pattern material after sequentially performing plural times the pattern material supply process, adherent liquid removal process, and drying process.

26. A pattern forming method **characterized by** sequentially performing plural times:

a pattern material supply process for supplying a liquid pattern material to a specific pattern forming trench disposed in a workpiece;
a solidifying process for heating and solidifying the liquid pattern material supplied to the trench; and
an adherent solid removal process for removing solids of the liquid pattern material that adhered to the workpiece surface when the liquid pattern material was supplied to the trench.

27. A pattern forming method comprising:

a pattern material supply process for supplying a liquid pattern material to a specific pattern forming trench disposed in a workpiece;
a drying process for evaporating solvent in the liquid pattern material supplied to the trench; and

an annealing process for annealing solute contained in the dried liquid pattern material after sequentially performing plural times the pattern material supply process and drying process.

28. A pattern forming method comprising:

a pattern material supply process for supplying a liquid pattern material to a specific pattern forming trench disposed in a workpiece;

a drying process for evaporating solvent in the liquid pattern material supplied to the trench;

an adherent solid removal process for removing dried solids of the liquid pattern material that adhered to the workpiece surface when the liquid pattern material was supplied to the trench; and

an annealing process for annealing solute contained in the dried liquid pattern material after sequentially performing plural times the pattern material supply process, drying process, and adherent solid removal process.

29. A pattern forming method **characterized by** performing once or plural times:

a pattern material supply process for supplying a liquid pattern material to a specific pattern forming trench disposed in a workpiece;

a drying process for evaporating solvent in the liquid pattern material supplied to the trench;

an adherent solid removal process for removing dried solids of the liquid pattern material that adhered to the workpiece surface when the liquid pattern material was supplied to the trench; and

an annealing process for annealing solute contained in the dried liquid pattern material.

30. A pattern forming method as described in any of claims 23 to 29, wherein: the liquid pattern material is supplied to the trench after hydrophobic processing the workpiece surface.

31. A pattern forming method as described in any of claims 23 to 29, wherein: the liquid pattern material is supplied to the trench after hydrophobic processing the workpiece surface, and hydrophilic processing the trench bottom.

32. A pattern forming method as described in claim 23, claim 24, or claim 26, wherein: the liquid pattern material is solidified by heating the liquid pattern material.

33. A pattern forming method as described in claim 32, wherein: heating and solidifying the liquid pattern material comprises a drying process for evaporating solvent in the liquid pattern material, and an annealing process for annealing the dried solute.

34. A pattern forming method as described in claim 23, **characterized by** solidifying the liquid pattern material and then removing solids of the liquid pattern material that adhered to the workpiece surface when the liquid pattern material was supplied to the trench.

35. A pattern forming method as described in claim 23, wherein solidifying the liquid pattern material is performed after removing liquid pattern material that adhered to the workpiece surface when the liquid pattern material was supplied to the trench.

36. A pattern forming method as described in claim 27, wherein the annealing process is performed after removing dried solids of liquid pattern material that adhered to the workpiece surface when the liquid pattern material was supplied to the trench.

37. A pattern forming method comprising:

a process for disposing an organic film on a workpiece surface;

a process for forming a trench of a specific pattern in the organic film;

a process for filling the trench with an inorganic material;

a process for removing inorganic material except from inside the trench; and

a process for removing the organic film and leaving a pattern of the inorganic material.

38. A pattern forming method as described in claim 37, wherein the process for filling the trench with an inorganic material is accomplished by applying a solution containing the inorganic material.

39. A pattern forming method as described in claim 38, wherein the inorganic material is a liquid or a liquid-gas mixture.

40. A pattern forming method as described in claim 38 or claim 39, wherein: the inorganic material is applied by spin coating.

41. A pattern forming method as described in claim 38 or claim 39, wherein: the inorganic material is applied spraying.

42. A pattern forming method as described in claim 37, wherein: the process for removing inorganic material except inside the trench is accomplished by applying an etching solution.

43. A pattern forming method as described in claim 42, wherein: the etching solution is a liquid or a liquid-gas mixture.

44. A pattern forming method as described in claim 42 or claim 43, wherein: the etching solution is applied by spin etching.

45. A pattern forming method as described in claim 42 or claim 43, wherein: the etching solution is applied by spraying.

46. A pattern forming method as described in claim 37, wherein: the process for removing inorganic material except inside the trench is accomplished by CMP.

47. A pattern forming method as described in claim 37, wherein: the organic film is removed with atmospheric pressure plasma.

48. A pattern forming apparatus comprising:

a mask forming unit for forming a mask by disposing pattern forming openings in a mask material coated to and solidified on a workpiece surface;
a hydrophobic processing unit for hydrophobic processing the solidified mask material or mask;
a pattern material supply unit for supplying a liquid pattern material to the pattern forming openings of the mask; and
a solidification unit for solidifying the liquid pattern material in the pattern forming openings.

49. A pattern forming apparatus comprising:

a mask forming unit for forming a mask by disposing pattern forming openings in a mask material coated to and solidified on a workpiece surface;
a hydrophobic processing unit for hydrophobic processing the solidified mask material or mask;
a pattern material supply unit for supplying a liquid pattern material to the pattern forming openings of the mask;
a solidification unit for solidifying the liquid pattern material in the pattern forming openings; and
a mask removal unit for removing the mask after solidifying the liquid pattern material.

50. A pattern forming apparatus as described in claim 48 or claim 49, wherein: the hydrophobic processing unit comprises a plasma generating means for producing a fluoride gas plasma at atmospheric pressure or near atmospheric pressure, and supplying the plasma to the solidified mask material or mask.

51. A pattern forming apparatus as described in claim 48 or claim 49, wherein: the hydrophobic processing unit comprises a polymerization means for producing a fluorocompound plasma, and polymerizing a fluororesin film on the surface of the solidified mask material or mask.

52. A pattern forming apparatus as described in claim 50 or claim 51, wherein: the hydrophobic processing unit comprises a hydrophilic processing means for making inside the pattern forming openings of the hydrophobic processed mask hydrophilic.

53. A pattern forming apparatus comprising:

a mask forming unit for forming a mask comprising a hydrophobic film having pattern forming openings on the surface of a workpiece;
a pattern material supply unit for supplying a liquid pattern material to the pattern forming openings of the mask;
a solidification unit for solidifying the liquid pattern material in the pattern forming openings; and
a mask removal unit for removing the mask after solidifying the liquid pattern material.

54. A pattern forming apparatus as described in claim 50, wherein: the mask forming unit comprises a polymerization means for producing a fluorocompound plasma, and polymerizing a fluororesin film on the surface of the workpiece through a transfer mask.

55. A pattern forming apparatus as described in any of claims 48 to 54, wherein: the pattern material supply unit comprises an adherent liquid removal means for removing liquid pattern material adhering to the mask surface.

56. A pattern forming apparatus as described in any of claims 48 to 54, wherein: the pattern material supply unit comprises an atomization means for atomizing and misting the liquid pattern material on the mask.

57. A pattern forming apparatus as described in claim 56, wherein: the pattern material supply unit comprises a rotating means for rotating the workpiece.

58. A pattern forming apparatus as described in claim 56 or claim 57, wherein: the pattern material supply unit comprises a voltage applying means for applying a voltage to the workpiece so that static attraction works to attract the atomized liquid pattern material to the workpiece.

**59.** A pattern forming apparatus as described in any of claims 48 to 58, wherein: the solidification unit comprises a heating means disposed in the pattern material supply unit for heating and solidifying the liquid pattern material.

**60.** A semiconductor device **characterized by** being manufactured using a pattern forming method as described in any of claims 1 to 47.

**61.** An electrical circuit **characterized by** being manufactured using a pattern forming method as described in any of claims 1 to 47.

**62.** A display module **characterized by** being manufactured using a pattern forming method as described in any of claims 1 to 47.

**63.** A color filter **characterized by** being manufactured using a pattern forming method as described in any of claims 1 to 47.

**64.** A light-emitting element **characterized by** being manufactured using a pattern forming method as described in any of claims 1 to 36.

FIG._1

FIG._2

*200*

CF₄

*210*

*216*

*212*

*220*

*214*

*20*

*218*

## FIG._3

*314*

*300*

*316*

*311*

*310*

*312*

*330*

*20*

*326*

*318*

*328*

*324*

*322*

*320*

*332*

## FIG._4

FIG._5

FIG._6

*S100*

MASK FORMING
PROCESS

HYDROPHOBIC
MASK

*S101*

MASK
HYDROPHOBIC
PROCESS

*S102*

PATTERN
MATERIAL SUPPLY
PROCESS

*S103*

ADHERENT
LIQUID REMOVAL
PROCESS

*S104*

PATTERN
MATERIAL DRYING
PROCESS

*S105*

MASK REMOVAL
PROCESS

*S106*

PATTERN MATERIAL
ANNEALING PROCESS

*FIG._7*

*S110*

MASK FORMING

HYDROPHOBIC
MASK
*S111*

MASK
HYDROPHOBIC
PROCESS

*S112*

PATTERN
MATERIAL SUPPLY

SIMULTANEOUS
DRYING

*S113*

PATTERN
MATERIAL DRYING

*S114*

DRIED SOLID
REMOVAL PROCESS

*S115*

MASK REMOVAL
PROCESS

*S116*

PATTERN MATERIAL
ANNEALING PROCESS

*FIG._8*

```
         ┌─────────────────┐
         │  MASK FORMING   │
         │    PROCESS      │──── S120
         └─────────────────┘
                  │
                  │   HYDROPHOBIC
                  │      MASK
         ─ ─ ─ ─ ─↓─ ─ ─ ─ ─ ─ ┐
                     ┌─ S121    │
         ┌─────────────────┐    │
         │      MASK       │    │
         │   HYDROPHOBIC   │    │
         │     PROCESS     │    │
         └─────────────────┘    │
                  │             │
         ─ ─ ─ ─ ─↓← ─ ─ ─ ─ ─ ─┘
         ┌─────────────────┐
         │     PATTERN     │
         │ MATERIAL SUPPLY │──── S122
         │     PROCESS     │
         └─────────────────┘
                  │
                  ↓
         ┌─────────────────┐
         │     PATTERN     │
         │ MATERIAL DRYING │──── S123
         │     PROCESS     │
         └─────────────────┘
                  │
                  ↓
         ┌─────────────────┐
         │     PATTERN     │
         │MATERIAL ANNEALING│─── S124
         │     PROCESS     │
         └─────────────────┘
                  │
                  ↓
         ┌─────────────────┐
         │  MASK REMOVAL   │
         │    PROCESS      │──── S125
         └─────────────────┘
```

*FIG._9*

S130 — MASK FORMING PROCESS

↓

S131 — MASK HYDROPHOBIC PROCESS

↓

S132 — PATTERN MATERIAL SUPPLY PROCESS

↓

S133 — MASK MATERIAL HEATING AND SOLIDFYING PROCESS

FIG._10

MASK FORMING PROCESS — S140

HYDROPHOBIC MASK

MASK HYDROPHOBIC PROCESS — S141

PATTERN MATERIAL SUPPLY PROCESS — S142

SIMULTANEOUS DRYING

PATTERN MATERIAL DRYING PROCESS — S143

DRIED SOLID REMOVAL PROCESS — S144

PATTERN MATERIAL ANNEALING PROCESS — S145

MASK REMOVAL PROCESS — S146

## FIG._11

MASK FORMING PROCESS — S150

HYDROPHOBIC MASK

S151

MASK HYDROPHOBIC PROCESS

PATTERN MATERIAL SUPPLY PROCESS — S152

PATTERN MATERIAL DRYING PROCESS — S153

PATTERN MATERIAL ANNEALING PROCESS — S154

MASK REMOVAL PROCESS — S155

*FIG._12*

S160

WORKPIECE
HYDROPHOBIC
PROCESS

S161

PATTERN
MATERIAL SUPPLY
PROCESS

S162

ADHERENT
LIQUID REMOVAL
PROCESS

S163

PATTERN MATERIAL
HEATING AND
SOLIDFYING PROCESS

*FIG._13*

S180

WORKPIECE
HYDROPHOBIC
PROCESS

S181

PATTERN
MATERIAL SUPPLY
PROCESS

S182

PATTERN MATERIAL
HEATING AND
SOLIDIFICATION

*FIG._15*

S170

WORKPIECE
HYDROPHOBIC
PROCESS

S171

PATTERN
MATERIAL SUPPLY
PROCESS

S172

ADHERENT
LIQUID REMOVAL
PROCESS

S173

PATTERN
MATERIAL DRYING
PROCESS

S174

PATTERN MATERIAL
ANNEALING PROCESS

FIG._14

S190

WORKPIECE
HYDROPHOBIC
PROCESS

S191

PATTERN
MATERIAL SUPPLY
PROCESS

S192

PATTERN
MATERIAL DRYING
PROCESS

S193

DRIED SOLID
REMOVAL PROCESS

S194

PATTERN MATERIAL
ANNEALING PROCESS

S193a

SOLID MATERIAL
REMOVAL PROCESS

*FIG._16*

FIG._17

*FIG._18-1*

*FIG._18-2*

*FIG._18-3*

*FIG._19-1*

*FIG._19-2*

*FIG._19-3*

FIG._20-1

FIG._20-2

FIG._20-3

FIG._21-1

FIG._21-2

FIG._21-3

614 (600A) — 612 — 612 — 614 (600C)

602

614 (600B)

*FIG._22-1*

616 — 618 — 616

620 — 614 — 602

614

612 — 614 (600B) — 612

*FIG._22-2*

622 — 620 — 602

620 — 618
614

612 — 614 — 612

*FIG._22-3*

**FIG._23-1**

**FIG._23-2**

FIG._24-1

FIG._24-2

FIG._24-3

FIG._25-1

FIG._25-2

FIG._25-3

FIG._26-1

FIG._26-2

*FIG._27-1*

*FIG._27-2*

*FIG._27-3*

*FIG._27-4*

FIG._28-1

FIG._28-2

FIG._28-3

FIG._28-4

FIG._29-1

FIG._29-2

700

702

704

FIG._30

710

716   712

714

FIG._31

*FIG._32*

*FIG._33-1*

*FIG._33-2*

*FIG._33-3*

FIG._34-1

FIG._34-2

FIG._34-3

## INTERNATIONAL SEARCH REPORT

| International application No. |
| --- |
| PCT/JP01/11308 |

**A. CLASSIFICATION OF SUBJECT MATTER**
    Int.Cl⁷ H01L21/306

According to International Patent Classification (IPC) or to both national classification and IPC

**B. FIELDS SEARCHED**

Minimum documentation searched (classification system followed by classification symbols)
    Int.Cl⁷ H01L21/306, H01L21/768

Documentation searched other than minimum documentation to the extent that such documents are included in the fields searched
    Jitsuyo Shinan Koho          1964–1996    Toroku Jitsuyo Shinan Koho    1994–1998
    Kokai Jitsuyo Shinan Koho    1971–1996    Jitsuyo Shinan Toroku Koho    1996–2002

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP, 2000-260865, A (Tri-Chemical Lab,Inc.), 22 September, 2000 (22.09.00), Par. Nos. [0020] to [0051] (Family: none) | 1-3,12,23,24, 29,32,37-41, 53,60-64 |
| Y | | 5-9,13-22,25-29,31,33-36, 42-47 |
| Y | JP, 2000-188266, A (NKK Corp.), 04 July, 2000 (04.07.00), Par. Nos. [0016] to [0052] (Family: none) | 5-9,13-22,25-29,31,33-36, 42-47 |
| Y | JP, 05-152243, A (Nippon Steel Corp.), 18 June, 1993 (18.06.93), Par. Nos. [0018] to [0039] (Family: none) | 5-9,13-22,25-29,31,33-36, 42-47 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 08 March, 2002 (08.03.02) | 19 March, 2002 (19.03.02) |

| Name and mailing address of the ISA/ | Authorized officer |
| --- | --- |
| Japanese Patent Office | |
| Facsimile No. | Telephone No. |

Form PCT/ISA/210 (second sheet) (July 1998)

**EP 1 345 261 A1**

## INTERNATIONAL SEARCH REPORT

| | International application No. |
|---|---|
| | PCT/JP01/11308 |

C (Continuation). DOCUMENTS CONSIDERED TO BE RELEVANT

| Category* | Citation of document, with indication, where appropriate, of the relevant passages | Relevant to claim No. |
|---|---|---|
| Y | US, 6004631, A (Seiko Epson Corp.),<br>21 December, 1999 (21.12.99),<br>Column 2, line 32 to column 19, line 21<br>& JP 08-279494 A | 5-9,13-22,25-<br>29,31,33-36,<br>42-47 |
| A | WO, 96/15289, A (Simon Fraser University),<br>23 May, 1996 (23.05.96),<br>Page 5, line 29 to page 19, line 23 | 10,11,30,<br>48-52,54-59 |

Form PCT/ISA/210 (continuation of second sheet) (July 1998)

61